# EUROPEAN PATENT APPLICATION

(11) **EP 4 468 328 A1**
(43) Date of publication of application: **27.11.2024**
(21) Application number: 24169019.7
(22) Date of filing: 08.04.2024
(51) Int. Cl.: H01L 21/67, H01L 21/677

(54) **SUBSTRATE TRANSFER APPARATUS, AND APPARATUS FOR PROCESSING SUBSTRATE PROVIDED WITH SUBSTRATE TRANSFER APPARATUS**

(30) Priority: 07.04.2023 JP 2023062559
(71) Applicant: EBARA CORPORATION, Ota-ku, Tokyo 144-8510 (JP)
(72) Inventor: FURUSAWA, Manato, Tokyo (JP); FUJISAWA, Mao, Tokyo (JP)
(74) Representative: Klang, Alexander H.

(57) **Abstract**

One object is to suppress a substrate in a rectangular shape from being damaged when the substrate is transferred through a process of spraying a liquid and/or a gas to the substrate. There is provided a substrate transfer apparatus configured to transfer a substrate in a rectangular shape. The substrate transfer apparatus comprises a plurality of first transfer rollers configured to support a lower face of the substrate; a plurality of first roller shafts, wherein at least three first transfer rollers are mounted to each of the first roller shafts; a motor configured to rotate the first roller shafts; a plurality of second transfer rollers configured to support an upper face of the substrate at only a center portion of the substrate in a width direction; a plurality of second roller shafts, wherein one second transfer roller configured to support only the center portion of the substrate in the width direction is mounted to each of the second roller shafts; and a plurality of guide rollers opposed to respective side faces of the substrate and configured to guide transfer of the substrate.

## Description

### TECHNICAL FIELD

The present disclosure relates to a substrate transfer apparatus and an apparatus for processing a substrate, which is provided with the substrate transfer apparatus.

### BACKGROUND ART

In manufacture of semiconductor devices, chemical mechanical polishing (CMP) apparatus have been used to planarize the surface of a substrate. In many cases, substrates used for manufacture of semiconductor devices are in a disk-like shape. There has been an increasing demand for the high degree of flatness in the case of planarization of the surface of a substrate in a rectangular shape, for example, CCL substrates (copper clad laminate substrates), PCB (printed circuit board) substrates, photomask substrates, and display panels, other than the semiconductor devices.

For example, in CMP apparatus described in Japanese Unexamined Patent Publication No. 2020-009987 (PTL 1) and Japanese Unexamined Patent Publication No. 2020-053421 (PTL 2), a substrate is transferred by a roller conveyor to a subsequent unit. During transfer of the substrate, a polishing solution remaining on the substrate is washed out by rinsing with pure water. In order to prevent the substrate from being pushed back by the water pressure in the course of rinsing with pure water, the substrate is held between an upper roller and a lower roller to resist the flow of rinsing. The roller conveyor is provided with guide rollers on respective lateral sides of the substrate, with a view to preventing the substrate from being deviated from a transfer pathway.

### CITATION LIST

### PATENT LITERATURES

PTL 1: Japanese Unexamined Patent Publication No. 2020-009987
PTL 2: Japanese Unexamined Patent Publication No. 2020-053421

### SUMMARY OF INVENTION

### TECHNICAL PROBLEM

CCL substrates are mainstream of semiconductor package substrates. Attention has, however, recently been drawn to glass substrates that have linear thermal expansion coefficients equivalent to silicon and that have little warpage by a temperature change even when the glass substrate is bonded to a semiconductor device. Especially, using thin glass substrates having thicknesses of less than 0.5 mm has been increasing with a reduction in thickness of the semiconductor device.

In the case where a thin substrate (for example, a thin glass substrate) is transferred by the substrate transfer method described above, the configuration of holding the substrate by the upper and the lower rollers restricts the rotation of the substrate in a horizontal direction. When the substrate meanders, the substrate is likely to be pressed against the guide roller and to be cracked or broken. Omission of pressing by the upper roller to release the substrate from this restriction, however, the thin substrate is likely to be swept away in the course of rinsing and is thus not likely to be normally transferred. When the weight of the upper roller is excessively increased, on the other hand, the substrate cannot bear a load from the upper roller and is likely to be cracked or broken. Similar problems arise not only in the case of rinsing with pure water but in the case of drying with spray of a gas such as the air or nitrogen.

Recently there has also been a demand to transfer substrates having different thicknesses (for example, glass substrates) by using a common transfer mechanism. The problems described above accordingly become prominent.

One object of the present disclosure is to solve at least one of the problems described above. One object of the present disclosure is to suppress a substrate in a rectangular shape from being damaged when the substrate is transferred through a process of spraying a liquid and/or a gas. One object of the present disclosure is to suppress a substrate in a rectangular shape having a different thickness from being damaged when the substrate is transferred through a process of spraying a liquid and/or a gas.

### SOLUTION TO PROBLEM

According to one aspect of the present disclosure, there is provided a substrate transfer apparatus configured to transfer a substrate in a rectangular shape. The substrate transfer apparatus comprises a plurality of first transfer rollers configured to support a lower face of the substrate; a plurality of first roller shafts, wherein at least three first transfer rollers are mounted to each of the first roller shafts, such as to support at least respective end portions and a center portion of the substrate in a width direction that is perpendicular to a transfer direction of the substrate; a motor configured to rotate the first roller shafts; a plurality of second transfer rollers configured to support an upper face of the substrate at only the center portion of the substrate in the width direction; a plurality of second roller shafts, wherein one second transfer roller configured to support only the center portion of the substrate in the width direction is mounted to each of the second roller shafts; and a plurality of guide rollers opposed to respective side faces of the substrate and configured to guide transfer of the substrate.

### BRIEF DESCRIPTION OF DRAWINGS

Fig. 1 is a plan view illustrating the general configuration of a substrate processing apparatus according to one embodiment;
Fig. 2 is a side view schematically illustrating a loading unit according to one embodiment;
Fig. 3 is a plan view schematically illustrating a substrate that is an object to be processed, according to one embodiment;
Fig. 4 is a side view schematically illustrating a transfer unit according to one embodiment;
Fig. 5 is a perspective view illustrating the transfer unit according to one embodiment;
Fig. 6 is a perspective view schematically illustrating a polishing unit according to one embodiment;
Fig. 7 is a side view schematically illustrating a drying unit according to one embodiment;
Fig. 8 is a side view schematically illustrating an unloading unit according to one embodiment;
Fig. 9 is a view illustrating a housing of the transfer unit as one example;
Fig. 10 is a plan view illustrating a transfer mechanism in the vicinity of a cleaning module of the transfer unit according to one embodiment;
Fig. 11 is a sectional view, taken along a line XI-XI of Fig. 10;
Fig. 12 is a sectional view, taken along a line XII-XII of Fig. 10;
Fig. 13 is a perspective view illustrating the transfer mechanism with close-up of the periphery of a pressing roller;
Fig. 14 is a side view illustrating a support mechanism of the pressing roller;
Fig. 15 is explanatory views illustrating driving systems according to different diameters of the pressing roller;
Fig. 16 is a plan view illustrating a transfer mechanism in the vicinity of the cleaning module of the transfer unit according to one embodiment;
Fig. 17 is a sectional view, taken along a line XVII-XVII of Fig. 16;
Fig. 18 is a sectional view, taken along a line XVIII-XVIII of Fig. 16;
Fig. 19 is a perspective view illustrating a transfer mechanism with close-up of the periphery of upper transfer rollers;
Fig. 20 is a side view illustrating a support mechanism of the upper transfer rollers, viewed from inside of a transfer pathway;
Fig. 21 is a side view illustrating the support mechanism of the upper transfer rollers, viewed from outside of the transfer pathway;
Fig. 22 is explanatory views illustrating driving systems according to different diameters of the upper transfer rollers;
Fig. 23 is a perspective view illustrating auxiliary rollers between transfer rollers; and
Fig. 24 is a schematic diagram illustrating an example of adding upper transfer rollers in a neighborhood of an inlet/ outlet of a unit.

### DESCRIPTION OF EMBODIMENTS

The following describes embodiments of a substrate transfer apparatus and a substrate processing apparatus provided with the substrate transfer apparatus according to the present disclosure, with reference to the attached drawings. In the attached drawings, identical or similar elements or components are represented by identical or similar reference signs. In the description of the respective embodiments, duplicated explanation about the identical or similar elements or components may be omitted. The characteristics and the features expressed in each of the embodiments are applicable to the other embodiments, unless they contradict each other.

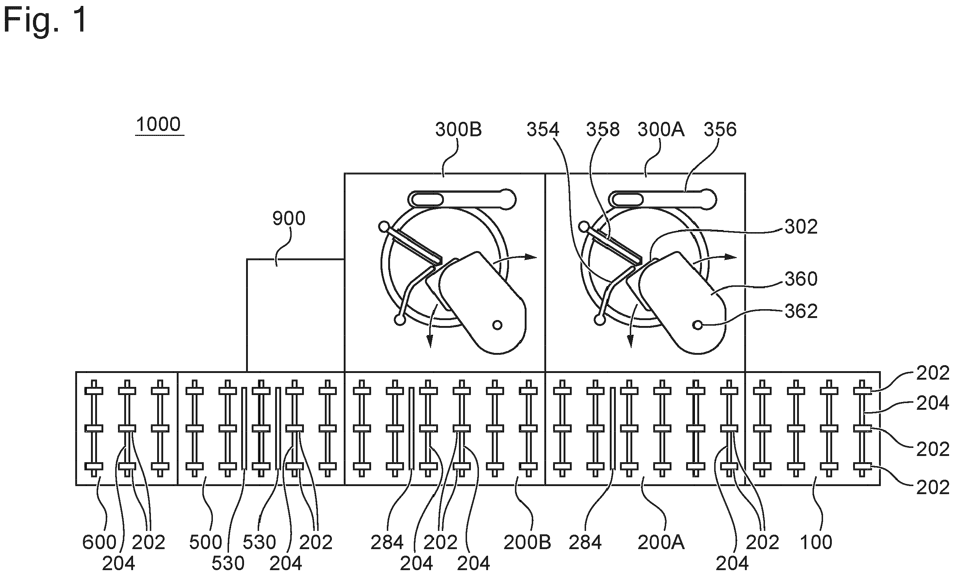

Fig. 1 is a plan view illustrating the general configuration of a substrate processing apparatus 1000 according to one embodiment. The substrate processing apparatus 1000 shown in Fig. 1 includes a loading unit 100, a transfer unit 200, a polishing unit 300, a drying unit 500 and an unloading unit 600. In the illustrated embodiment, the transfer unit 200 includes two transfer units 200A and 200B, and the polishing unit 300 includes two polishing units 300A and 300B. According to one embodiment, each of these units may be formed independently. Forming these units independently enables the substrate processing apparatus 1000 of different configurations to be readily formed by combining arbitrary numbers of the respective units. The substrate processing apparatus 1000 also includes a controller 900. The respective components of the substrate processing apparatus 1000 are controlled by the controller 900. According to one embodiment, the controller 900 may be configured by a general computer including, for example, an input/ output device, an arithmetic device, and a storage device.

### <Loading Unit>

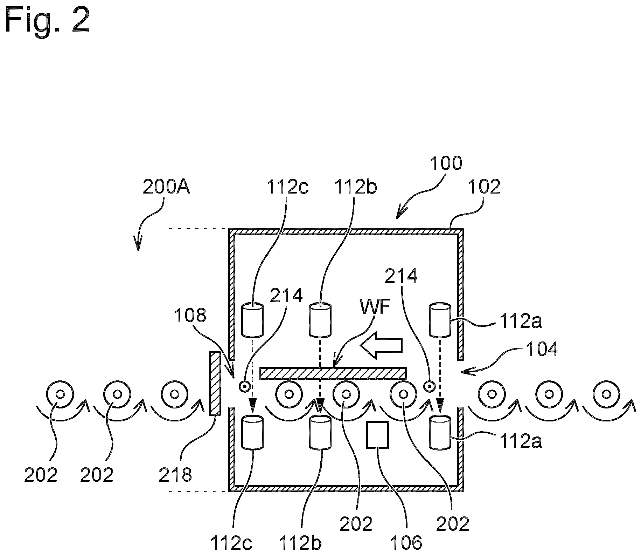

The loading unit 100 is a unit configured to carry a substrate WF that is prior to processes including polishing and cleaning, into the substrate processing apparatus 1000. Fig. 2 is a side view schematically illustrating the loading unit 100 according to one embodiment. In one embodiment, the loading unit 100 includes a housing 102. The housing 102 has an inlet opening 104 on a side where the substrate WF is received. In the embodiment shown in Fig. 2, the right side is the inlet side. The loading unit 100 receives the substrate WF that is an object to be processed or a processing object, from the inlet opening 104. A processing apparatus where processes or treatments are performed prior to processing of the substrate WF by the substrate processing apparatus 1000 of the present disclosure, is placed upstream (on a right side in Fig. 2) of the loading unit 100. In the embodiment shown in Fig. 2, the loading unit 100 includes an ID reader 106. The ID reader 106 reads an ID of each substrate received through the inlet opening 104. The substrate processing apparatus 1000 performs various processes for the substrate WF according to the read ID. According to one embodiment, the ID reader 106 may be omitted. According to one embodiment, the loading unit 100 is configured in conformity with Mechanical Equipment Interface Standard (IPC-SMEMA-9851) by SMEMA (Surface Mount Equipment Manufactures Association).

In the embodiment shown in Fig. 2, the loading unit 100 is provided with a plurality of transfer rollers 202 configured to transfer the substrate WF. In the embodiment below, the transfer rotors 202 may be referred to as lower transfer rollers 202. Rotating the transfer rollers 202 enables the substrate WF on the transfer rollers 202 to be transferred in a predetermined direction (leftward in Fig. 2). In the illustrated embodiment, the housing 102 of the loading unit 100 has an outlet opening 108 for the substrate WF. The loading unit 100 is equipped with sensors 112 configured to detect the presence or the absence of the substrate WF at predetermined positions on the transfer rollers 202. The sensors 112 may be any arbitrary types of sensors and may be, for example, optical sensors. In the embodiment shown in Fig. 2, three sensors 112 are provided inside of the housing 102: one is a sensor 112a provided in the vicinity of the inlet opening 104; one is a sensor 112b provided in the vicinity of the center of the loading unit 100; and the last one is a sensor 112c provided in the vicinity of the outlet opening 108. According to the embodiment, the operations of the loading unit 100 may be controlled, based on the detection of the substrate WF by these sensors 112. For example, when the sensor 112a placed in the vicinity of the inlet opening 104 detects the presence of the substrate WF, the rotation of the transfer rollers 202 in the loading unit 100 may be started, or the rotation speed of the transfer rollers 202 may be changed. In another example, when the sensor 112c placed in the vicinity of the outlet opening 108 detects the presence of the substrate WF, an inlet shutter 218 of the transfer unit 200A that is a subsequent unit may be opened.

A transfer mechanism of the loading unit 100 includes the plurality of transfer rollers 202 and a plurality of roller shafts 204 which the transfer rollers 202 are mounted to. In the illustrated embodiment, three transfer rollers 202 provided to support respective end portions and a center portion in a width direction of the substrate WF (a direction perpendicular to a transfer direction of the substrate WF) are mounted to each roller shaft 204. The substrate WF is placed on the transfer rollers 202 and is transferred by rotating the transfer rollers 202. The mounting positions of the transfer rollers 202 on the roller shaft 204 may be any positions as long as the positions allow the substrate WF to be stably transferred. The transfer rollers 202, however, come into contact with the substrate WF and are thus to be placed at such positions that bring the transfer rollers 202 into contact with areas of the substrate WF as the processing object, which causes no problem or no trouble by the contact. According to one embodiment, the transfer rollers 202 of the loading unit 100 may be made of a conductive polymer. According to one embodiment, the transfer rollers 202 are electrically grounded via the roller shafts 204 and the like. This prevents the substrate WF from being charged and damaged. According to one embodiment, the loading unit 100 may be provided with an ionizer (not shown) configured to prevent the substrate WF from being charged. The loading unit 100 is also provided with guide rollers (not shown) configured to support side faces of the substrate WF during transfer.

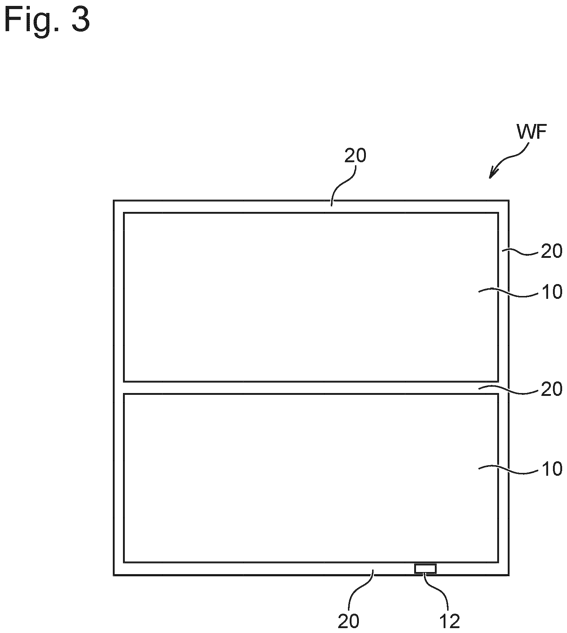

Fig. 3 is a plan view schematically illustrating the substrate WF that is an object to be processed, according to one embodiment. As shown in Fig. 3, according to one embodiment, the substrate WF is a thin plate-like glass substrate in an approximately rectangular shape (including a square shape). The substrate WF shown in Fig. 3 has pattern areas 10 and non-pattern areas 20. The "pattern area" is an area provided with wiring, functional chips and the like and is an area that is used as a device formed on the substrate and that is provided with wiring, functional chips and the like significant for the functions of the device. The "non-pattern area" is an area that is not used as a device on the substrate. In the embodiment shown in Fig. 3, the substrate WF has two pattern areas 10, each of which is surrounded by the non-pattern areas 20. According to one embodiment, the substrate WF may include ID information of the substrate WF in the non-pattern area 20 and may be provided with, for example, an ID tag 12. The ID information of the substrate WF may be read by the ID reader 106 described above. The substrate WF may be a substrate in an approximately rectangular shape other than the glass substrate. The substrate WF may be, for example, a resin substrate.

The loading unit 100 receives and transfers the substrate WF in such a state that a face of the substrate WF with the pattern areas 10 formed thereon as shown in Fig. 3 faces down. Accordingly, the transfer rollers 202 are placed such as to come into contact with only the non-pattern areas 20 of the substrate WF. More specifically, as shown in Fig. 1, the transfer rollers 202 are provided at such positions as to come into contact with the non-pattern areas 20 on the respective end portions of the substrate WF and at such positions as to come into contact with the non-pattern area 20 in the center portion of the substrate WF. The positions of the transfer rollers 202 may be changed according to the substrate WF that is an object to be processed. The configuration of the illustrated embodiment is thus applicable to transfer the substrate WF having different dimensions or different patterns by changing the mounting positions of the transfer rollers 202 to the roller shafts 204. Rectangular substrates do not have set dimensions by the standard, unlike circular semiconductor substrates. The transfer mechanism of the embodiment according to the present disclosure is thus advantageously configured to transfer the substrate of various dimensions by a minor or subtle change.

In the embodiment shown in Fig. 1, the roller shafts 24 are rotary-driven by a motor (not shown) via gears (not shown). According to one embodiment, the motor may be a servomotor. Using the servomotor enables the rotation speeds of the roller shafts 204 and the transfer rollers 202, i.e., the transfer speed of the substrate WF, to be controlled. According to one embodiment, the gear may be a magnet gear. The magnet gear is a contactless power transmission mechanism. The magnet gear is accordingly free from generation of fine particles caused by abrasion, unlike a contact gear, and does not need maintenance such as refueling.

As shown in Fig. 2, the loading unit 100 is provided with auxiliary rollers 214 in the vicinity of the inlet opening 104 and in the vicinity of the outlet opening 108. The auxiliary rollers 214 are placed at heights approximately equivalent to the heights of the transfer rollers 202. The positions of the auxiliary rollers 214 may be changed according to the dimensions of the substrate WF that is transferred. The auxiliary rollers 214 serve to support the substrate WF, with a view to preventing the substrate WF during transfer from falling into between the loading unit 100 and another unit. The auxiliary rollers 214 are not connected with any power source and are configured to be freely rotatable.

According to one embodiment, the loading unit 100 may be provided with an inverting machine (not shown) to invert the received substrate WF. In the illustrated embodiment, the loading unit 100 receives and transfers the substrate WF in the state that the face of the substrate WF with the pattern areas 10 formed thereon faces down. In the case where the substrate WF is transferred into the loading unit 100 in such a state that the face of the substrate WF with the pattern areas 10 formed thereon faces up, due to the specification of an upstream processing apparatus, the inverting machine may serve to invert the substrate WF such that the face of the substrate WF with the pattern areas 10 formed thereon faces down and may perform subsequent processes in the substrate processing apparatus 1000.

### <Transfer Unit>

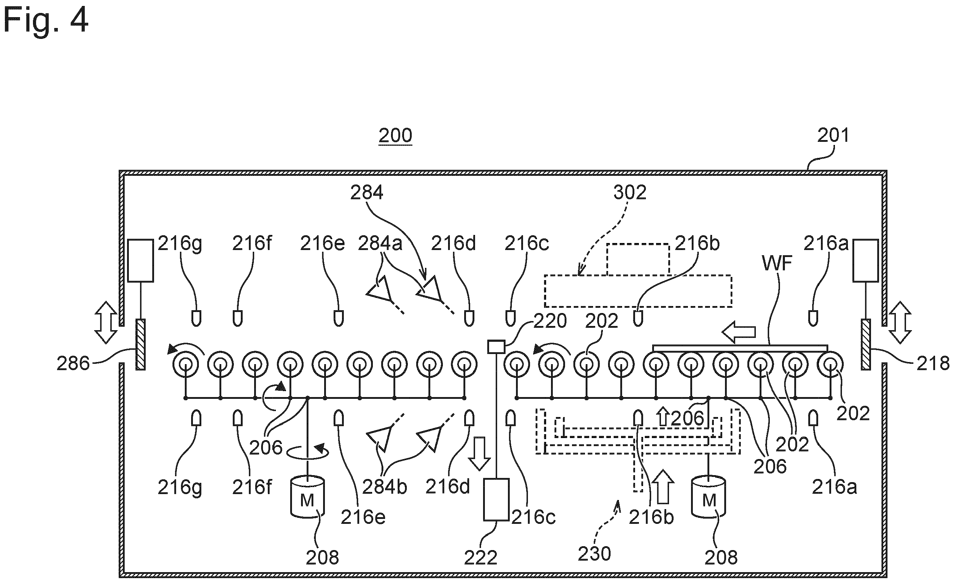

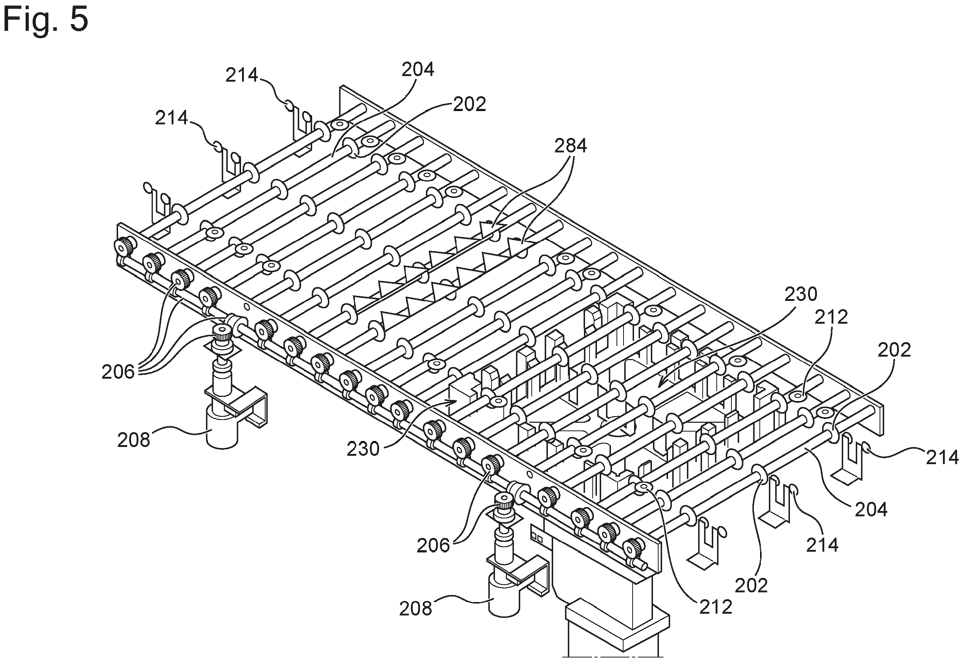

Fig. 4 is a side view schematically illustrating the transfer unit 200 according to one embodiment. Fig. 5 is a perspective view illustrating the transfer unit 200 according to one embodiment. The substrate processing apparatus shown in Fig. 1 has two transfer units 200A and 200B. The two transfer units 200A and 200B have identical configurations and are thus described collectively as the transfer unit 200 in the following description. Pressing rollers 702 and upper transfer rollers 802 (descried later) are omitted from the illustrations of Fig. 4 and Fig. 5.

In the illustrated embodiment, the transfer unit 200 has a housing 201. The illustrated transfer unit 200 is provided with a plurality of transfer rollers 202 that are configured to transfer the substrate WF. Rotating the transfer rollers 202 enables the substrate WF on the transfer rollers 202 to be transferred in a predetermined direction. The transfer rollers 202 of the transfer unit 200 may be made of a conductive polymer or may be made of a non-conductive polymer. The transfer rollers 202 are mounted to roller shafts 204 and are driven by a motor 208 via gears 206, like the transfer mechanism of the loading unit 100 described above. According to one embodiment, the motor 208 may be a servomotor, and the gear 206 may be a toothed wheel or may be a magnet gear, like the loading unit 100. The illustrated transfer unit 200 also has guide rollers 212 configured to support side faces of the substrate WF during transfer, like the loading unit 100. The illustrated transfer unit 200 has sensors 216 provided to detect the presence or the absence of the substrate WF at predetermined positions on the transfer rollers 202. The sensors 216 may be sensors of any arbitrary type and are, for example, optical sensors. In the embodiment shown in Fig. 4, seven sensors 216 (216a to 216g) are provided in the transfer unit 200. According to one embodiment, the operations of the transfer unit 200 may be controlled, in response to detection of the substrate WF by these sensors 216a to 216g. The positions and the functions of these respective sensors 216a to 216g will be described later. As shown in Fig. 4, the transfer unit 200 has an inlet shutter 218 configured to be openable and closable such as to receive the substrate WF into the transfer unit 200.

As shown in Fig. 4, the transfer unit 200 has a stopper 220. The stopper 220 is connected with a stopper moving mechanism 222 and is allowed to enter a transfer pathway of the substrate WF that moves on the transfer rollers 202. When the stopper 220 is located in the transfer pathway of the substrate WF, the stopper 220 comes into contact with a side face of the substrate WF moving on the transfer rollers 202 and stops the moving substrate WF at the position of the stopper 220. When the stopper 220 is located at a retreat position away from the transfer pathway of the substrate WF, the substrate WF is allowed to move on the transfer rollers 202. The stop position of the substrate WF by the stopper 220 is a position where a pusher 230 described later is allowed to receive the substrate WF on the transfer rollers 202 (substrate transfer position).

As shown in Fig. 4 and Fig. 5, the transfer unit 200 has a pusher 230. The pusher 230 is configured to lift up the substrate WF located on the plurality of transfer rollers 202 such as to be away from the plurality of transfer rollers 202 and transfer the lifted-up substrate WF to a top ring 302 (described later) of the polishing unit 300. The pusher 230 is also configured to transfer the substrate W received from the top ring 302 (described later) to the transfer rollers 202 of the transfer unit 200.

The transfer unit 200 shown in Fig. 4 and Fig. 5 has a cleaning module. As shown in Fig. 4 and Fig. 5, the cleaning module has cleaning nozzles 284. The cleaning nozzles 284 include upper cleaning nozzles 284a placed on an upper side of the transfer rollers 202 and lower cleaning nozzles 284b placed on a lower side of the transfer rollers 202. The upper cleaning nozzles 284a and the lower cleaning nozzles 284b are connected with a non-illustrated supply source of a cleaning solution. The upper cleaning nozzles 284a are configured to supply the cleaning solution to an upper face of the substrate WF that is transferred on the transfer rollers 202. The lower cleaning nozzles 284b are configured to supply the cleaning solution to a lower face of the substrate WF that is transferred on the transfer rollers 202. The upper cleaning nozzles 284a and the lower cleaning nozzles 284b have widths equivalent to or greater than the width of the substrate WF that is transferred on the transfer rollers 202, and are configured such that the entire faces of the substrate WF are cleaned while the substrate WF is transferred on the transfer rollers 202. The cleaning nozzles 284 (the upper cleaning nozzles 284a and the lower cleaning nozzles 284b) are placed such that fluid spray directions from the cleaning nozzles 284 are directions against a substrate transfer direction (i.e., a direction opposite to the substrate transfer direction), with a view to improving the cleaning capacity. The fluid spray direction that is identical with the substrate transfer direction lowers a relative speed of the sprayed fluid to the substrate, makes it difficult to move and remove polishing residues (abrasive grains) and liquid droplets on the substrate, and thereby lowers the cleaning capacity. As shown in Fig. 4 and Fig. 5, the cleaning module is located on a downstream side of the substrate transfer position by the pusher 230 in the transfer unit 200.

The sensor 216d is placed in the vicinity of an inlet of the cleaning module. According to one embodiment, in response to detection of the substrate WF by the sensor 216d, the cleaning solution may be sprayed from the cleaning nozzles 284 to start cleaning of the substrate WF. During cleaning of the substrate WF, the rotation speed of the transfer rollers 202 may be set to a speed for cleaning. In the embodiment shown in Fig. 4, the sensor 216f is placed in the vicinity of an outlet of the cleaning module. According to one embodiment, in response to detection of the substrate WF by the sensor 216f, the spray of the cleaning solution from the cleaning nozzles 284 may be terminated.

The transfer unit 200 has an outlet shutter 286 configured to be openable and closable. The transfer unit 200 is also provided with the sensor 216g in the vicinity of the outlet. According to one embodiment, in response to detection of the substrate WF by the sensor 216g, the outlet shutter 286 may be opened, so as to allow the substrate WF to be transferred to a subsequent unit. According to one embodiment, in response to detection of the substrate WF by the sensor 216g, the transfer of the substrate WF by the transfer rollers 202 may be stopped without opening the outlet shutter 286 to wait for processing by the subsequent unit. After the subsequent unit becomes ready for acceptance of a substrate, the outlet shutter 286 may be opened, so as to allow the substrate WF to be transferred to the subsequent unit.

### <Polishing Unit>

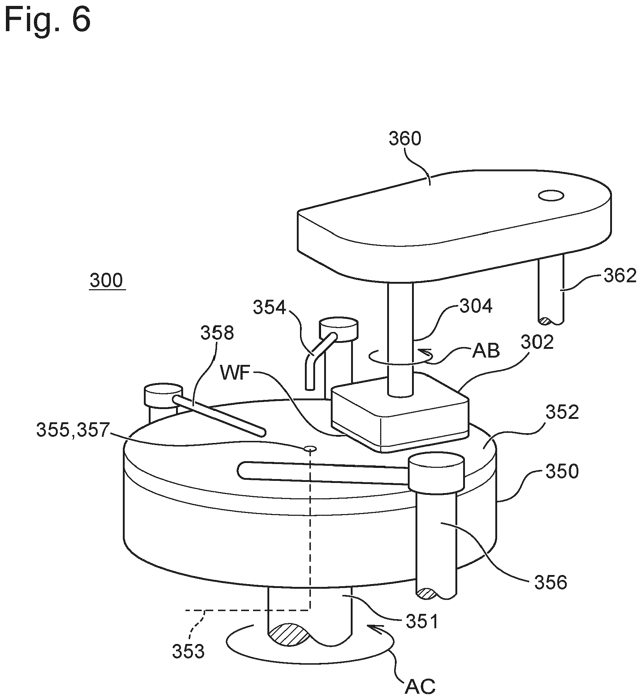

Fig. 6 is a perspective view schematically illustrating the polishing unit 300 according to one embodiment. The substrate processing apparatus 1000 shown in Fig. 1 has two polishing units 300A and 300B. The two polishing units 300A and 300B have identical configurations and are thus described collectively as the polishing unit 300 in the following description.

The polishing unit 300 includes a polishing table 350 and a top ring 302. The polishing table 350 is rotary-driven by a non-illustrated driving source. A polishing pad 352 is attached to the polishing table 350. According to one embodiment, the polishing pad 352 may be attached via a layer that facilitates separation from the polishing table 350. Examples of such a layer include a silicone layer and a fluororesin layer, and a substance described in, for example, Japanese Unexamined Patent Publication No. 2014-176950 may be used for this layer. The top ring 302 is configured to hold the substrate WF and press the substrate WF against the polishing pad 352. The top ring 302 is rotary-driven by a non-illustrated driving source. The substrate WF is held by the top ring 302 such as to be pressed against the polishing pad 352 and thereby polished.

According to one embodiment, a groove is provided on the surface of the polishing pad 352. This groove serves to control the flow of a polishing solution supplied onto the surface of the polishing pad 352. The groove may have any size, any depth, any sectional shape, and any pattern.

The polishing unit 300 includes a polishing solution supply nozzle 354 configured to supply a polishing solution or a dressing solution to the polishing pad 352. The polishing solution is, for example, slurry. The dressing solution is, for example, pure water. A passage 353 is provided in the polishing table 350 and in a table shaft 351 to supply the polishing solution. The passage 353 is connected with an opening 355 on the surface of the polishing table 350. A through hole 357 is formed in the polishing pad 352 at a position corresponding to the opening 355 of the polishing table 350. The polishing solution passing through the passage 353 is supplied from the opening 355 of the polishing table 350 and the through hole 357 of the polishing pad 352 to the surface of the polishing pad 352. The opening 355 of the polishing table 350 and the through hole 357 of the polishing pad 352 may be one opening and one through hole or may be plural openings and plural through holes. The opening 355 of the polishing table 350 and the through hole 357 of the polishing pad 352 may be provided at any arbitrary position but are placed in the vicinity of the center of the polishing table 350 according to one embodiment. The polishing unit 300 also includes a dresser 356 configured to condition the polishing pad 352. The polishing unit 300 further includes an atomizer 358 configured to spray a liquid or a mixed fluid of a liquid and a gas toward the polishing pad 352. The liquid sprayed from the atomizer 358 is, for example, pure water, and the gas sprayed from the atomizer 358 is, for example, nitrogen gas.

The top ring 302 is supported by a top ring shaft 304. The top ring 302 is configured to rotate about an axial center of the top ring shaft 304 as shown by an arrow AB by a non-illustrated driving part. The top ring shaft 304 is configured to be movable in a vertical direction by a non-illustrated driving mechanism. The polishing table 350 is supported by the table shaft 351. The polishing table 350 is configured to rotate about an axial center of the table shaft 351 as shown by an arrow AC by a non-illustrated driving part.

The substrate WF is held on a face of the top ring 302 that is opposed to the polishing pad 352, by vacuum suction. At the time of polishing, the polishing solution is supplied from the polishing solution supply nozzle 354 and/or from the through hole 357 of the polishing pad 352 to a polishing surface of the polishing pad 352. At the time of polishing, the polishing table 350 and the top ring 302 are rotary-driven. The substrate WF is pressed against the polishing surface of the polishing pad 352 by the top ring 302 so as to be polished.

The top ring shaft 304 is linked with an arm 360 that is swingable about a rotation shaft 362. The arm 360 may be fixed or may be swung such that the top ring 302 passes through the center of the polishing pad 352 during polishing of the substrate WF. Furthermore, the arm 360 may be fixed or may be swung such that the substrate WF covers over the through hole 357 of the polishing pad 352 during polishing of the substrate WF. As shown in Fig. 1, the top ring 302 is movable toward the transfer unit 200 by the arm 360 that is swingable. When the top ring 302 moves to the substrate transfer position of the transfer unit 200, the top ring 302 is allowed to receive the substrate WF from the pusher 230 (substrate transfer mechanism). After polishing of the substrate WF in the polishing unit 300, the top ring 302 is also allowed to transfer the substrate WF to the pusher 230.

### <Drying Unit>

The drying unit is a device configured to dry the substrate WF. In the substrate processing apparatus 1000 shown in Fig. 1, the drying unit 500 is configured to dry the substrate WF that has been polished by the polishing unit 300 and that has subsequently been cleaned by the cleaning module of the transfer unit 200. As shown in Fig. 1, the drying unit 500 is placed downstream of the transfer unit 200.

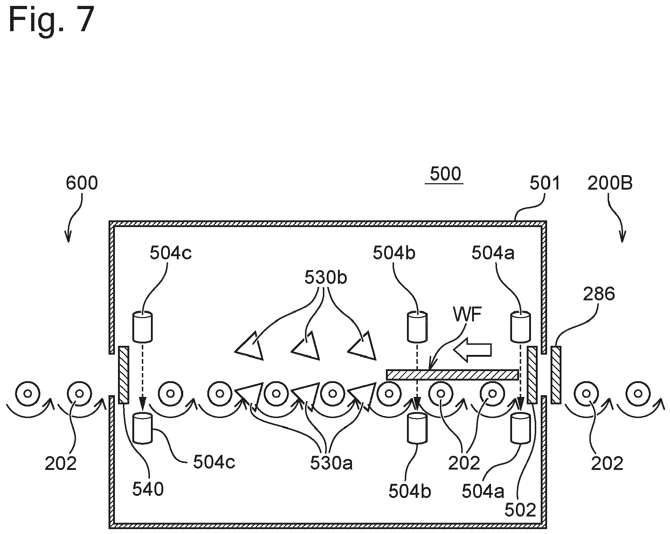

Fig. 7 is a side view schematically illustrating the drying unit 500 according to one embodiment. The pressing rollers 702 and the upper transfer rollers 802 (descried later) are omitted from the illustration of Fig. 7. The drying unit 500 is provided with transfer rollers 202 that are configured to transfer the substrate WF. According to one embodiment, the transfer rollers 202 of the drying unit 500 may be made of a conductive polymer. The transfer rollers 202 are electrically grounded via roller shafts 204 and the like. This prevents the substrate WF from being charged and damaged. According to one embodiment, the drying unit 500 may be provided with an ionizer (not shown) configured to prevent the substrate WF from being charged. Like the transfer rollers 202 of the transfer unit 200, the transfer rollers 202 of the drying unit 500 are driven by gears 206 and a motor 208. An inlet shutter 502 is provided on an inlet side of the drying unit 500. The inlet shutter 502 is configured to be openable and closable. The drying unit 500 is equipped with sensors 504 configured to detect the presence or the absence of the substrate WF at predetermined positions on the transfer rollers 202. The sensors 504 may be any arbitrary types of sensors and may be, for example, optical sensors. In the embodiment shown in Fig. 7, three sensors 504 (504a to 504c) are provided in the drying unit 500. According to one embodiment, the operations of the drying unit 500 may be controlled, in response to detection of the substrate WF by these sensors 504a to 504c. The positions and the functions of these respective sensors 504a to 504c will be described later.

In the embodiment shown in Fig. 7, the drying unit 500 is provided with nozzles 530 configured to spray a gas toward the substrate WF that is transferred on the transfer rollers 202. The gas may be, for example, the compressed air or nitrogen. In the illustrated embodiment, the nozzles 530 include lower nozzles 530a placed on a lower side of the transfer rollers 202 and upper nozzles 530b placed on an upper side of the transfer rollers 202. The lower nozzles 530a are placed to spray the gas to a lower face of the substrate WF that is transferred on the transfer rollers 202. The upper nozzles 530b are placed to spray the gas to an upper face of the substrate WF that is transferred on the transfer rollers 202. The lower nozzles 530a and the upper nozzles 530b have widths equivalent to or greater than the width of the transferred substrate WF. This configuration enables the lower nozzles 530a and the upper nozzles 530b to spray the gas over the entirety of the transferred substrate WF. The drying unit 500 causes water droplets on the transferred substrate WF to be blown off by the lower nozzles 530a and the upper nozzles 530b and thereby dries the substrate WF. The lower nozzles 530a and the upper nozzles 530b may be one lower nozzle and one upper nozzle or may be plural lower nozzles and plural upper nozzles that are arrayed in the transfer direction of the substrate WF. The configuration of the embodiment shown in Fig. 7 has three upper nozzles 530b and three lower nozzles 530a. The form of each nozzle 530 is, for example, a slit-like form by extending a gas supply port to approximately the width of the substrate WF. The nozzles 530 (the lower nozzles 530a and the upper nozzles 530b) are placed such that the gas spray directions from the nozzles 530 are directions against the substrate transfer direction (directions opposite to the substrate transfer direction), with a view to enhancing the drying capacity. The gas spray direction that is identical with the substrate transfer direction lowers a relative speed of the sprayed gas to the substrate, makes it difficult to move and remove the water droplets on the substrate, and thereby lowers the drying capacity.

### <Unloading Unit>

The unloading unit 600 is a unit configured to carry out the substrate WF that has been subjected to processes including polishing and cleaning, to outside of the substrate processing apparatus 1000. In the substrate processing apparatus 1000 shown in Fig. 1, the unloading unit 600 is configured to receive the substrate that has been dried by the drying unit 500. As shown in Fig. 1, the unloading unit 600 is placed downstream of the drying unit 500.

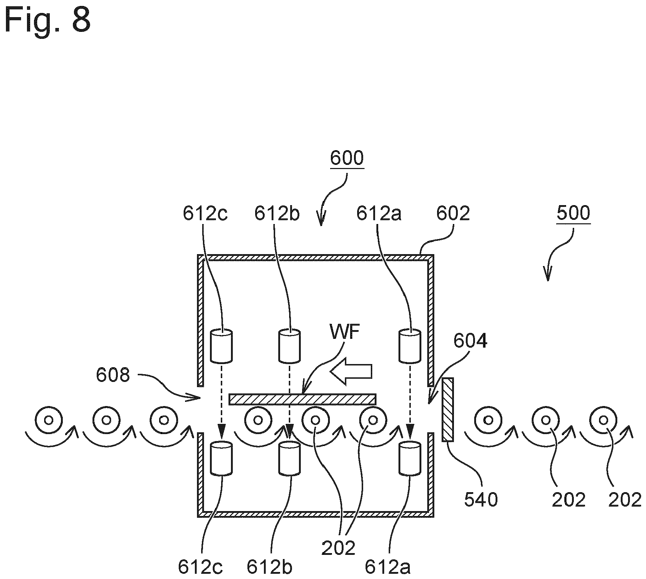

Fig. 8 is a side view schematically illustrating the unloading unit 600 according to one embodiment. In the illustrated embodiment, the unloading unit 600 includes a housing 602. The housing 602 has an inlet opening 604 on a side where the substrate WF is received. In the illustrated embodiment, the right side is the inlet side. The unloading unit 600 receives the substrate WF from the inlet opening 604. According to one embodiment, the unloading unit 600 is configured in conformity with Mechanical Equipment Interface Standard (IPC-SMEMA-9851) by SMEMA (Surface Mount Equipment Manufactures Association).

In the illustrated embodiment, the unloading unit 600 is provided with a plurality of transfer rollers 202 configured to transfer the substrate WF. Rotating the transfer rollers 202 enables the substrate on the transfer rollers 202 to be transferred in a predetermined direction. According to one embodiment, the transfer rollers 202 of the unloading unit 600 may be made of a conductive polymer. According to one embodiment, the transfer rollers 202 are electrically grounded via roller shafts 204 and the like. This prevents the substrate WF from being charged and damaged. According to one embodiment, the unloading unit 600 may be provided with an ionizer (not shown) configured to prevent the substrate WF from being charged.

In the illustrated embodiment, the housing 602 of the unloading unit 600 has an outlet opening 608 for the substrate WF. The unloading unit 600 is provided with sensors 612 configured to detect the presence or the absence of the substrate WF at predetermined positions on the transfer rollers 202. The sensors 612 may be any arbitrary types of sensors and may be, for example, optical sensors. In the illustrated embodiment, three sensors 612 are provided inside of the housing 602: one is a sensor 612a provided in the vicinity of the inlet opening 604; one is a sensor 612b provided in the vicinity of the center of the unloading unit 600; and the last one is a sensor 612c provided in the vicinity of the outlet opening 608. According to the embodiment, the operations of the unloading unit 600 may be controlled, based on the detection of the substrate WF by these sensors 612. For example, when the sensor 612a placed in the vicinity of the inlet opening 604 detects the presence of the substrate WF, the rotation of the transfer rollers 202 in the unloading unit 600 may be started, or the rotation speed of the transfer rollers 202 may be changed. According to one embodiment, in the case where the loading unit 100 requires an inverting machine, the unloading unit 600 may also be provided with an inverting machine (not shown) configured to invert the substrate WF.

### <Transfer Pathway of Substrate>

The following describes a transfer pathway of the substrate WF in the substrate processing apparatus 1000 described above. The operations of the substrate processing apparatus 1000 are controlled by the controller 900. Another processing apparatus is placed upstream of the substrate processing apparatus 1000. The substrate WF that has been processed by another processing apparatus placed on the upstream side is carried from the inlet opening 104 of the loading unit 100 into the substrate processing apparatus 1000. In the embodiment described above, the substrate WF is transferred in such a state that a polishing surface of the substrate WF that is a surface to be polished by the polishing unit 300 faces down. According to one embodiment, the loading unit 100 may be configured to start the operations of the transfer rollers 202 of the loading unit 100, in response to detection of the substrate WF by the sensor 112a of the loading unit 100. The ID of the substrate WF carried into the loading unit 100 is read by the reader 106. The processing to be performed in the substrate processing apparatus 1000 may be determined according to the read ID. When it is determined that the carried-in substrate WF is not a processing object by the substrate processing apparatus 1000, based on the read ID, the transfer of the substrate WF by the transfer rollers 202 may be stopped. When the substrate WF is transferred by the transfer rollers 202 in the loading unit 100, the substrate WF is detected by the sensor 112c. In the case where the substrate WF is detected by the sensor 112c and the transfer unit 200A is ready for receiving the substrate WF, the inlet shutter 218 of the transfer unit 200A is opened, and the substrate WF is transferred by the transfer rollers 202 from the loading unit 100 into the transfer unit 200A. In the case where the transfer unit 200A is not yet ready for receiving the substrate WF, the loading unit 100 stops the operation of the transfer rollers 202 and waits until the transfer unit 200A becomes ready for receiving the substrate WF.

When the substrate WF is transferred to the transfer unit 200A, the sensor 216a placed on the inlet side of the transfer unit 200A detects the substrate WF. When it is detected that a rear end portion of the substrate WF has passed through the sensor 216a, the inlet shutter 218 is closed. The substrate WF is subsequently transferred by the transfer rollers 202 in the transfer unit 200A, while the sensor 216b monitors the position of the substrate WF. In the meantime, the stopper 220 is moved into the transfer pathway of the substrate WF by the stopper moving mechanism 222. The substrate WF transferred on the transfer rollers 202 comes into contact with the stoper 220 and stops. The sensor 216c is placed at the position of the stopper 220. The operation of the transfer rollers 202 is stopped, in response to detection of the substrate WF by the sensor 216c. The substrate WF stopped at the position of the stopper 220 (substrate transfer position) is transferred via the pusher 230 to the top ring 302 of the polishing unit 300A.

When the substrate WF is stopped at the substrate transfer position, the arm 360 of the polishing unit 300A is swung to locate the top ring 302 above the substrate WF in the transfer unit 200A. The pusher 230 then lifts up the substrate WF, and the top ring 302 holds the substrate WF by vacuum suction. After the substrate WF is held by the top ring 302, the arm 360 is swung to locate the top ring 302 holding the substrate WF at a position opposed to the polishing pad 352 in the polishing unit 300A. While the polishing table 350 and the top ring 302 are rotated, the substrate WF is then pressed against the polishing pad 352 to be polished. During polishing of the substrate WF, the polishing solution is supplied to the surface of the polishing pad 352 through the polishing solution supply nozzle 354 and the passage 353.

When polishing of the substrate WF is completed in the polishing unit 300A, the arm 360 is swung to move the top ring 302 holding the substrate WF to the substrate transfer position of the transfer unit 200A. The substrate WF is subsequently transferred to the pusher 230 by releasing the vacuum suction of the top ring 302. The pusher 230 is then lifted down to transfer the substrate WF onto the transfer rollers 202.

When polishing of the substrate WF is completed in the polishing unit 300A, dressing, cleaning and the like of the polishing pad 352 are performed by using the dresser 356, the atomizer 358 and the like in the polishing unit 300A.

When the substrate WF is transferred from the polishing unit 300A to the transfer unit 200A, the stopper 220 is moved away from the transfer pathway, and the transfer rollers 202 are restarted to transfer the substrate WF. The sensor 216d is provided at the position where cleaning of the substrate WF is started. Cleaning of the substrate WF is started, in response to detection of the substrate WF by the sensor 216d. At the time of cleaning of the substrate WF, the rotation speed of the transfer rollers 202 may be changed to a speed for cleaning. While the substrate WF is transferred by the transfer rollers 202, the cleaning solution is sprayed from the upper cleaning nozzles 284a and the lower cleaning nozzles 284b toward the substrate WF, so as to clean the substrate WF. The sensor 216e is placed inside of the cleaning module. The substrate WF is transferred with being cleaned, while the sensor 216e monitors the position of the substrate WF. The sensor 216f is placed at the position where cleaning of the substrate WF is terminated. Spraying the cleaning solution from the upper cleaning nozzles 284a and the lower cleaning nozzles 284b is stopped, in response to detection of the substrate WF by the sensor 216f. When cleaning of the substrate WF is concluded, the rotation speed of the transfer rollers 202 is changed to a speed for transfer. The sensor 216g is placed in the vicinity of the outlet of the transfer unit 200A. When the sensor 216g detects the substrate WF and a subsequent unit, i.e., the transfer unit 200B, is ready for receiving the substrate WF, the outlet shutter 286 is opened, so as to allow the substrate WF to be transferred from the transfer unit 200A to the transfer unit 200B. When the sensor 216g detects the substrate WF but the polishing unit 300B is not yet ready for receiving the substrate WF, the transfer rollers 202 stop rotation and cause the substrate WF to wait until the polishing unit 300B becomes ready for receiving the substrate WF.

According to one embodiment, processing of the substrate WF performed by the transfer unit 200B may be similar to the processing performed by the transfer unit 200A described above. This process typically includes the case where an identical substrate WF is polished in two stages by the polishing unit 300A and the polishing unit 300B. According to one embodiment, polishing of the substrate WF may be performed by only one of the polishing unit 300A and the polishing unit 300B (polishing in only one stage). For example, in the case where polishing of the substrate WF is performed only by the polishing unit 300A and is not performed by the polishing unit 300B, the transfer unit 200B transfers the substrate WF by the transfer rollers 202 to a subsequent unit, i.e., the drying unit 500, without transferring the substrate WF to the polishing unit 300B and without cleaning. In another example, in the case where polishing of the substrate WF is not performed by the polishing unit 300A but is performed by only the polishing unit 300B, the transfer unit 200A transfers the substrate WF by the transfer rollers 202 to a subsequent unit, i.e., the transfer unit 200B, without transferring the substrate WF to the polishing unit 300A and without cleaning.

In the substrate processing apparatus 1000 shown in Fig. 1, the substrate WF is transferred from the transfer unit 200B to the drying unit 500. When the substrate WF is to be received into the drying unit 500, the outlet shutter 286 of the transfer unit 200B and the inlet shutter 502 of the drying unit 500 are opened, and the substrate WF is transferred by the transfer rollers 202 from the transfer unit 200B to the drying unit 500. When it is detected that the substrate WF has passed through the sensor 504a placed in the vicinity of the inlet of the drying unit 500, the inlet shutter 502 of the drying unit 500 and the outlet shutter 286 of the transfer unit 200B are closed. The sensor 504b is placed at the position where drying of the substrate WF by the drying unit 500 is started. When the substrate WF transferred by the transfer rollers 202 in the drying unit 500 is detected by the sensor 504b, spraying the gas is started from the lower nozzles 530a and the upper nozzles 530b. At the time of drying the substrate WF, the rotation speed of the transfer rollers 202 may be changed to a speed for drying (for example, speed for drying < speed for transfer). In such a case, the rotation speed of the transfer rollers 202 is returned to the speed for transfer after termination of drying. The sensor 504c is placed in the vicinity of the outlet of the drying unit 500. Spraying the gas from the lower nozzles 530a and the upper nozzles 530b is stopped, in response to detection of the substrate WF by the sensor 504c. When the sensor 504c detects the substrate WF, the outlet shutter 540 is opened, so as to allow the substrate WF to be transferred from the drying unit 500 to the unloading unit 600.

The substrate WF received into the unloading unit 600 is transferred by the transfer rollers 202 to the outlet while being monitored by the sensors 612a to 612c, and is carried out from the outlet opening 608 to outside of the substrate processing apparatus 1000. Another processing apparatus configured to perform subsequent processes or treatments of the substrate WF is placed on the outlet side of the unloading unit 600. The substrate WF is transferred from the unloading unit 600 to another processing apparatus for subsequent processes or treatments.

### <Housing of Transfer Unit>

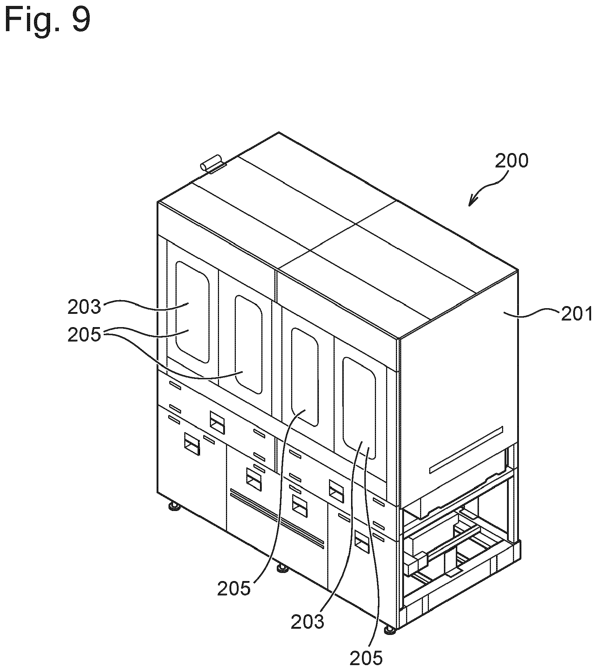

The substrate processing apparatus 1000 shown in Fig. 1 is provided with the two transfer units 200 and the two polishing units 300. The number of the transfer units 200 and the number of the polishing units 300 may respectively be one or may respectively be three or more. As described above, the loading unit 100, the transfer unit 200, the polishing unit 300, the drying unit 500, and the unloading unit 600 may be configured as independent units. A housing of each of these units may be provided with a window for observation of the inside thereof. Fig. 9 is a view illustrating a housing 201 of the transfer unit 200 as one example. As illustrated, the housing 201 of the transfer unit 200 has doors 203, which are openable and closable, on a front side thereof. The door 203 includes a window 205 used for observation of the inside of the transfer unit 200. A light-shielding member configured to shield the external light, for example, a light-shielding sheet, may be attached to the window 205. The light-shielding member is required to have such a degree of light blocking effect as to prevent photo-corrosion of the substrate WF when the light reaches the substrate WF. The casing 201 of the transfer unit 200 provided with the doors 203 and the windows 205 is illustrated as one example. The other units, e.g., the loading unit 100, the drying unit 500, and the unloading unit 600 may be provided with similar doors and/or windows.

### <Transfer Mechanism of Cleaning Module>

### (First Embodiment)

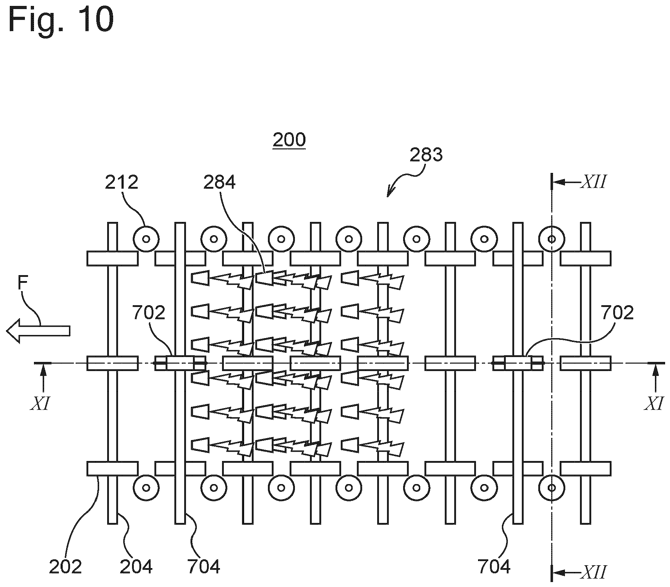

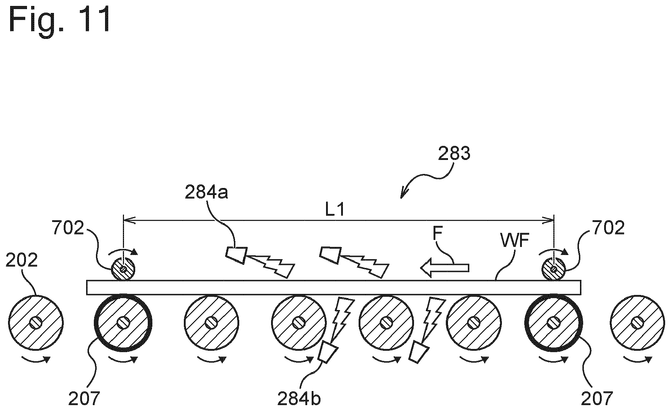

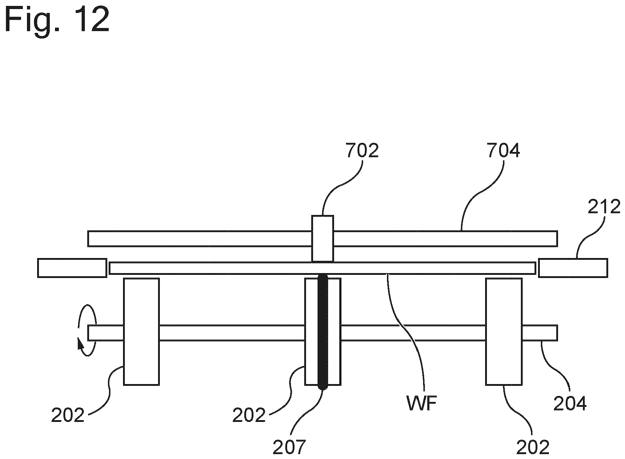

Fig. 10 is a plan view illustrating a transfer mechanism in the vicinity of a cleaning module 283 of the transfer unit 200 according to one embodiment. Fig. 11 is a sectional view, taken along a line XI-XI of Fig. 10. Fig. 12 is a sectional view, taken along a line XII-XII of Fig. 10. According to this embodiment, pressing rollers 702 (one example of second transfer rollers) configured to support/ press an upper face of the substrate WF by only a center portion thereof in a width direction (a direction perpendicular to a transfer direction F) are mounted to respective shafts 704 in the vicinity of the cleaning module 283 of the transfer unit 200. More specifically, the pressing rollers 702 are provided at positions coming into contact with the non-pattern area 20 in the center portion of the substrate WF shown in Fig. 3. The pressing rollers 702 (one example of the second transfer rollers) may have a round shape or a flat shape. The same applies to the shapes of the other rollers.

The cleaning module 283 may be a section between the sensor 216d and the sensor 216f shown in Fig. 4. The cleaning module 283 is provided with the cleaning nozzles 284 as described above (shown in Fig. 10). The cleaning nozzles 284 include the upper cleaning nozzles 284a placed on the upper side of the transfer rollers 202 (one example of first transfer rollers) and the lower cleaning nozzles 284b placed on the lower side of the transfer rollers 202 (shown in Fig. 11). The upper cleaning nozzles 284a and the lower cleaning nozzles 284b are connected with a non-illustrated supply source of the cleaning solution (for example, pure water). The upper cleaning nozzles 284a are configured to supply the cleaning solution to the upper face of the substrate WF that is transferred on the transfer rollers 202. The lower cleaning nozzles 284b are configured to supply the cleaning solution to the lower face of the substrate WF that is transferred on the transfer rollers 202. The upper cleaning nozzles 284a and the lower cleaning nozzles 284b have widths equivalent to or greater than the width of the substrate WF that is transferred on the transfer rollers 202, and are configured such that the entire faces of the substrate WF are cleaned while the substrate WF is transferred on the transfer rollers 202. The cleaning nozzles 284 (the upper cleaning nozzles 284a and the lower cleaning nozzles 284b) are placed such that the fluid spray directions from the cleaning nozzles 284 are directions against the substrate transfer direction (i.e., the direction opposite to the substrate transfer direction), with a view to improving the cleaning capacity.

In the illustrated embodiment, one pressing roller 702 (one shaft 704) is provided on an upstream side and one pressing roller 702 (one shaft 704) is provided on a downstream side of a cleaning area of the cleaning module 283 (an area where the substrate WF receives the supply of the cleaning solution) along the transfer direction F as shown in Fig. 11. The pressing rollers 702 on the upstream side and on the downstream side are placed at such positions and at such an interval L1 that the upper face of the substrate WF is continuously held by at least one of the pressing rollers 702 on the upstream side and on the downstream side, while the substrate WF is exposed to the cleaning solution from the cleaning nozzles 284 as shown in Fig. 11. For example, the interval L1 between the pressing rollers 702 on the upstream side and on the downstream side (a distance between center axes of respective rollers) is such a distance that the pressing rollers 702 on the upstream side and on the downstream side respectively and simultaneously come into contact with a front end portion and a rear end portion of the substrate WF along the transfer direction F, and is set to a slightly shorter length than the length of the substrate WF (a dimension along the transfer direction). This configuration enables the substrate WF to be continuously held by at least one pressing roller 702, while the substrate WF is exposed to the cleaning solution from the cleaning nozzles 284. In the state that no pressing roller 702 is brought into contact with the substrate WF, the substrate WF is swept away by the flow of the cleaning solution. In the state that two or more pressing rollers 702 are placed on the substrate WF, however, the substrate WF is not allowed to rotate in a horizontal direction and has a risk of being pressed against the guide roller 212 in the event of meandering of the substrate WF (a risk of being damaged). It is accordingly preferable to minimize a time period when the two pressing rollers 702 are brought into contact with the substrate WF. The above configuration that the interval L1 between the pressing rollers 702 is determined according to the length of the substrate WF (i.e., the configuration that the interval L1 is set to be slightly shorter than the length of the substrate WF, such that the pressing rollers 702 on the upstream side and on the downstream side are brought into contact with the substrate WF with being placed away from each other as much as possible in a length direction of the substrate WF) satisfies a condition that either one of the pressing rollers 702 is continuously brought into contact with the substrate WF and a condition that the time period when a plurality of pressing rollers 702 are brought into contact with the substrate WF is shortened as much as possible.

Two or more pressing rollers 702 arrayed in the transfer direction may be provided on each of the upstream side and the downstream side of the cleaning area of the cleaning module 283 to such a range as to assure a degree of freedom in rotation of the substrate WF in a horizontal direction. The number of the pressing rollers 702 (the number of the shafts 704) on the upstream side of the cleaning area of the cleaning module 283 may be different from the number of the pressing rollers 702 (the number of the shafts 704) on the downstream side. In the case where the cleaning area of the cleaning module 283 has a length that is significantly longer than the length of the substrate WF (for example, in the case where the cleaning area has a length that is approximately twice the length of the substrate WF), the pressing rollers 702 are placed not only on the upstream side and the downstream side of the cleaning area but in the middle of the cleaning area at such intervals set to the interval L1 (described above). In other words, two pressing rollers 702 or three or more pressing rollers 702 are provided at the interval L1 (described above) along the transfer direction in an area including the cleaning area (the cleaning area and the upstream side and the downstream side thereof), according to the length of the cleaning area.

In the state that the substrate WF is held in the width direction by a large number of transfer rollers (for example, the respective end portions and the center portion of the substrate WF in the width direction), the substrate WF is not allowed to freely rotate in the horizontal direction in the course of transfer. In the case where the substrate WF meanders to come into contact with the guide roller 212 in the course of transfer, the substrate WF securely held between the upper transfer rollers and the lower transfer rollers is constrained in rotation in the horizontal direction and is not allowed to be released. The substrate WF is then pressed hard against the guide roller 212 and is likely to be cracked in an arc shape. The configuration of the embodiment causes the substrate WF to be held downward from above by the pressing roller 702 at one position (only the center portion in the width direction) and thereby provides the substrate WF with a degree of freedom in rotation about the pressing roller 702. This configuration allows the substrate WF to freely rotate to some extent. Even when the substrate WF meanders to come into contact with the guide roller 212 in the course of transfer, this configuration allows the substrate WF to be released from the guide roller 212 (to rotate in a releasing direction) before being pressed hard against the guide roller 212, and thereby suppresses or prevents cracking of a side face of the substrate WF.

In the illustrated embodiment, the diameters of the pressing rollers 702 and the shafts 704 are set to be smaller than the diameters of the transfer rollers 202 and the shafts 204 on the lower side. Making the diameter of the pressing rollers 702 smaller than the diameter of the transfer rollers 202 allows the top ring 302 of the polishing unit 300 to move without interfering with the pressing rollers 702, even when there is a significant spatial restriction in the space above the transfer rollers 20. The pressing rollers 702 are not connected with any power source (any driving source) but are configured to be freely rotatable. In other words, the shafts 704 which the pressing rollers 702 are mounted to are not connected with any power source, and the pressing rollers 702 and the shafts 704 are driven to rotate with move of the substrate WF. A modification may place the shafts 704 to be not rotatable and may be configured such that the pressing roller 702 rotates about the shaft 704. According to another embodiment, the pressing rollers 702 (the shafts 704) may be connected with a power source to be rotary-driven (as described later).

In the illustrated embodiment, the transfer roller 202 corresponding to the pressing roller 702 or the transfer roller 202 located immediately below the pressing roller 702 may include a friction member 207 (shown in Fig. 11 and Fig. 12) or a friction material that enhances friction between the transfer roller 202 and the substrate WF. The friction member 207 may be an O ring or a rubber material provided in a portion of the transfer roller 202 (for example, an outer peripheral surface) that is expected to be brought into contact with the substrate WF or may be provided on part of the outer circumference or on the entire outer circumference of the transfer roller 202. The entirety or part of the transfer roller 202 may be made of a friction material (for example, rubber) that enhances friction between the transfer roller 202 and the substrate WF. For example, the transfer roller 202 may be a roller made of rubber. In this case, at least a portion of the transfer roller 202 that is expected to be brought into contact with the substrate WF is required to be made of a material having high friction. The configuration that the transfer roller 202 corresponding to the pressing roller 702 includes the friction member 207 or the friction material may be replaced by a configuration that the friction member 207 is provided on the pressing roller 702 or by a configuration that part or the entirety of the pressing roller 702 is made of the friction material. In another example, the friction member 207 or the friction material may be applied to both the pressing roller 702 and the corresponding transfer roller 202. In another example, the transfer roller 202 and/or the pressing roller 702 may be configured by combining the friction member 207 with the friction material. It is preferable to rotary-drive the roller including the friction member 207 and/or the friction material, in terms of effectively providing the substrate WF with a driving force in the transfer direction. This configuration enables the substrate WF (for example, a thin glass substrate) to be lightly held to such an extent as not to be broken or cracked but to resist the flow of the cleaning solution.

Increasing the weight of the pressing rollers 702 enables the pressing rollers 702 alone to press the substrate WF such as to prevent the substrate WF from being swept away by the flow of the cleaning solution. Increasing the weight of the pressing rollers 702, however, causes a risk of breaking or cracking the substrate WF (especially, a thin glass substrate of low strength). In the case where increasing the weight of the pressing rollers 702 is not allowed because of such a risk of cracking or breaking, using the friction member and/or the friction material for the pressing roller 702 and/or the transfer roller 202 corresponding to the pressing roller 702 as described above increases the friction between the substrate WF and the transfer roller 202 and/or the pressing roller 702 and restricts sliding of the substrate WF, so as to prevent the substrate WF from being swept away by the flow of the cleaning solution.

In the case where the pressing rollers 702 alone enable the substrate WF to resist against the flow of the cleaning solution without applying the friction member 207 or the friction material, the friction member 207 or the friction material may be omitted.

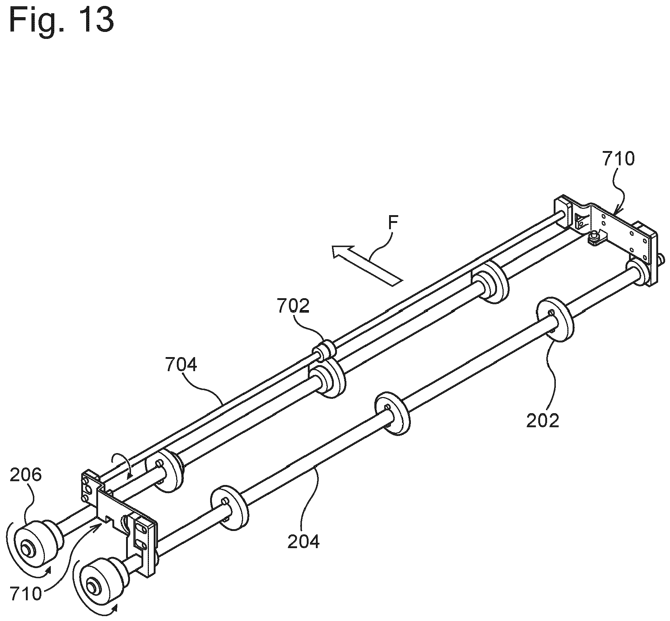

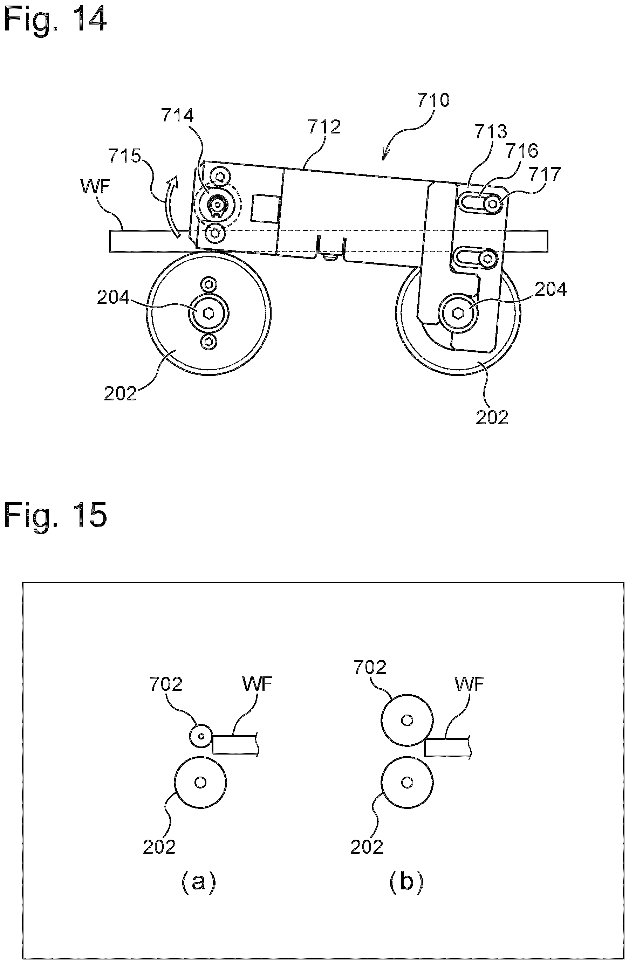

Fig. 13 is a perspective view illustrating the transfer mechanism with close-up of the periphery of the pressing roller 702. Fig. 14 is a side view illustrating a support mechanism of the pressing roller 702. The shaft 704 which the pressing roller 702 is mounted to is supported to be freely movable in a vertical direction by roller arms 710 provided on respective ends of the shaft 704. The respective ends of the shaft 704 are attached in a freely rotatable manner to leading ends of the roller arms 710. In the illustrated embodiment, the shaft 704 is attached in a freely rotatable manner to the roller arm 710 via a bearing or the like (not shown) placed in a bearing housing 714 at the leading end of the roller arm 710 shown in Fig. 14. A base end of the roller arm 710 is attached in a freely rotatable manner to the shaft 204 of the transfer rollers 202, which is located below and adjacent to the pressing roller 702 on an upstream side in the transfer direction F. In the state that the pressing roller 702 and the shaft 704 are lifted up by the substrate WF, the roller arms 710 rotate in the direction of an arrow 715 about the shaft 204/ around the shaft 204 as a fulcrum. The roller arm 710 includes an arm main body 712 and a bracket 713 attached by bolts 717 to the arm main body 712 via long holes 716. The roller arm 710 is configured to be readily detached from the shaft 204 for maintenance by loosening the bolts 717 and sliding the bracket 713 along the long holes 716 relative to the arm main body 712.

In the configuration shown in Fig. 13 and Fig. 14, when the substrate WF is transferred to the position of the pressing roller 702, the substrate WF lifts up the pressing roller 702 and the shaft 704 and causes the roller arms 710 to rotate in the direction of the arrow 715. This causes the substrate WF to lift up the pressing roller 702 and to pass through between the transfer roller 202 and the pressing roller 702. In this state, the substrate WF is held between the transfer roller 202 and the pressing roller 702. This accordingly suppresses the substrate WF from being swept away by the flow of the cleaning solution from the cleaning nozzles 284. Furthermore, the substrate WF is held by the pressing roller 702 at one location in the center portion thereof in the width direction. Even in the case where the substrate WF meanders and comes into contact with the guide roller 212, this configuration enables the substrate WF to be released from the guide roller 212 before being pressed hard against the guide roller 212. As a result, this configuration suppresses or prevents the substrate WF from being pressed hard against the guide roller 212 and from being damaged.

Fig. 15 is explanatory views illustrating driving systems according to different diameters of the pressing roller 702. In the case of driving the pressing roller 702, it is preferable to select a desired driving system according to the difference in diameter of the pressing roller 702. In the case where the diameter of the pressing roller 702 is smaller than the diameter of the transfer roller 202 as shown in Fig. 15(a) (on the contrary, in the case where the diameter of the pressing roller 702 is larger than the diameter of the transfer roller 202), it is preferable to connect the shaft 204 of the transfer rollers 202 with the shaft 704 of the pressing roller 702 by a belt for belt driving. The belt driving makes the circumferential speed of the pressing roller 702 equal to the circumferential speed of the transfer roller 202 and thereby efficiently moves the substrate WF forward. In the case where the diameter of the pressing roller 702 is as large as the diameter of the transfer roller 202 as shown in Fig. 15(b), the shaft 204 of the transfer rollers 202 may be connected with the shaft 704 of the pressing roller 702 by a belt for belt driving or may be connected with the shaft 704 of the pressing roller 702 directly via a gear without using a belt for gear driving (gear ratio 1:1). According to one embodiment, the gear may be a toothed wheel or may be a magnet gear. The magnet gear is a contactless power transmission mechanism. The magnet gear is accordingly free from generation of fine particles caused by abrasion, unlike a contact gear, and does not need maintenance such as refueling.

(Modifications of First Embodiment)
(1) In the embodiment described above, the pressing rollers 702 (the shafts 704) may be connected with a power source to be rotary-driven. Connecting the pressing rollers 702 (the shafts 704) with a power source, however, increases the weight of a configuration of pressing the substrate WF downward (the pressing rollers 702, the shafts 704, and a power transmission mechanism such as pullies, belts, and/or gears). It is accordingly preferable to increase the diameter of the pressing rollers 702 (for example, to be equivalent or even larger than the diameter of the transfer rollers 202), with a view to preventing a load from being locally concentrated on the substrate WF. In the case where the rotary driving of the pressing rollers 702 prevents the substrate from being swept away by the flow of the fluid, the friction member 207 or the friction material is not necessarily included in the pressing rollers 702 or the transfer rollers 202 on the lower side.
(2) In the embodiment described above, the configuration that the transfer rollers 202 include the friction member 207 or the friction material may be replaced by a configuration that the pressing rollers 702 include the friction member 207 or the friction material or may be replaced by a configuration that both the transfer rollers 202 and the pressing rollers 702 include the friction member 207 or the friction material. In the configuration that the pressing rollers 702 include the friction member 207 or the friction material, it is preferable to connect the pressing rollers 702 (the shafts 704) with a power source such as to be rotary-driven. In this case, the weight of the configuration that presses the substrate WF downward is increased as described above. It is accordingly preferable to increase the diameter of the pressing rollers 702 (for example, to be equivalent or even larger than the diameter of the transfer rollers 202), with a view to preventing a load from being locally concentrated on the substrate WF.
(3) In the embodiment described above, the configuration that the transfer rollers 202 and/or the pressing rollers 702 include the friction member 207 or the friction material may be replaced by a configuration that the weight of the pressing rollers 702 is increased (for example, to a maximum possible weight in such a range that does not damage the substrate WF), so as to prevent the substrate WF from being swept away by the flow of the cleaning solution. In this case, it is preferable to increase the diameter of the pressing rollers 702 (to be equivalent or even larger than the diameter of the transfer rollers 202), with a view to suppressing the weight of the pressing roller 702 from being locally imposed on the substrate WF. In this case, a configuration that the pressing rollers 702 are not connected with a power source and are not rotary-driven may be employed.

The embodiment and its modifications described above illustrate the exemplary configurations that the pressing rollers 702 and the like are provided in the location where the substrate WF receives a supply of the cleaning solution (a liquid or a mixed fluid of a liquid and a gas) from the cleaning nozzles 284. A similar configuration to any of the configurations of the above embodiment and the modifications thereof may be employed in a location where the substrate WF receives a supply of the gas (for example, in a location where the substrate WF receives a supply of the gas from the nozzles 530 in the drying unit 500). A configuration corresponding to the pressing rollers 702 and the upper transfer rollers 802 (descried later) is omitted from the illustration of Fig. 7.

### (Second Embodiment)

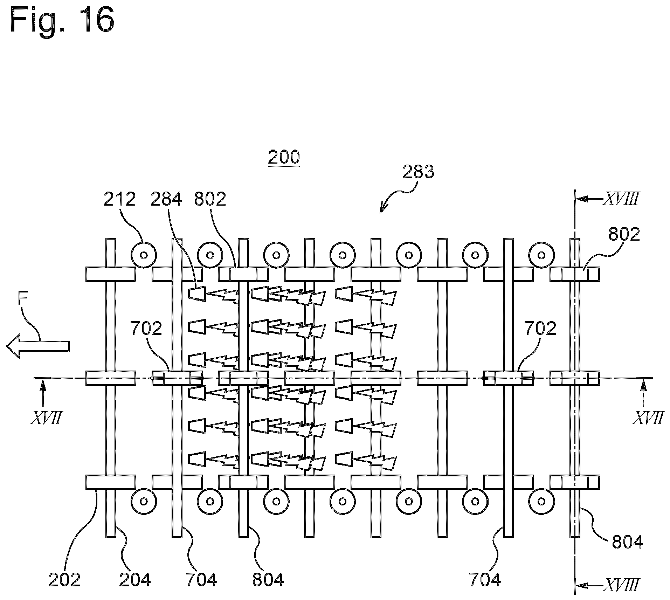

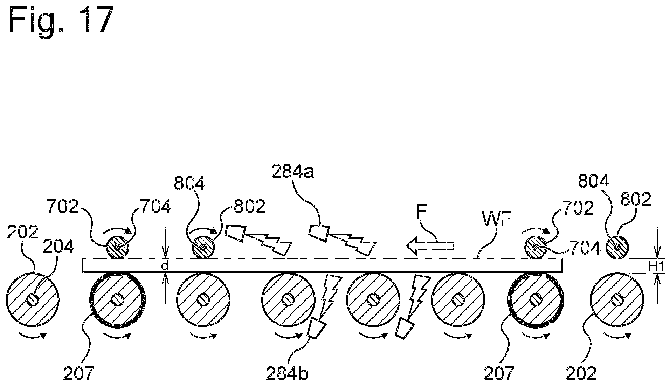

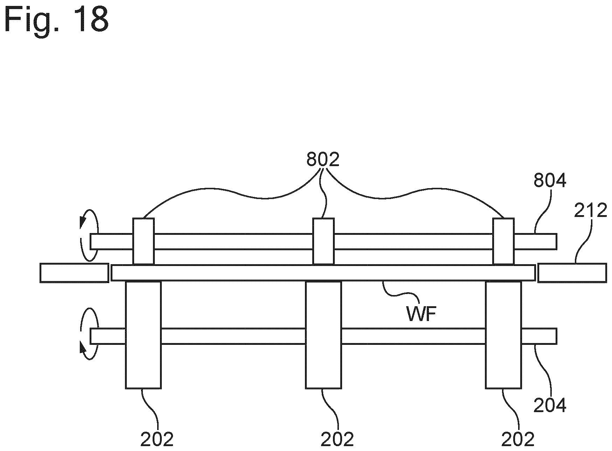

Fig. 16 is a plan view illustrating a transfer mechanism in the vicinity of the cleaning module 283 of the transfer unit 200 according to one embodiment. Fig. 17 is a sectional view, taken along a line XVII-XVII of Fig. 16. Fig. 18 is a sectional view, taken along a line XVIII-XVIII of Fig. 16. According to this embodiment, upper transfer rollers 802 (one example of third transfer rollers) that are rotary-driven are provided on an upstream side of the pressing roller 702 such as to come into contact with an upper face of the substrate WF, in addition to the configuration of the embodiment described above. In the illustrated embodiment, the upper transfer rollers 802 are provided corresponding to the transfer rollers 202 located on the upstream side of and adjacent to each pressing roller 702. Three upper transfer rollers 802 are provided on one shaft 804 (for example, at positions corresponding to the respective end portions and the center portion of the substrate WF in the width direction). The upper transfer rollers 802 are provided at positions corresponding to the respective transfer rollers 202 on the lower side or at positions immediately above the respective transfer rollers 202 on the lower side. According to one embodiment, four or more upper transfer rollers 802 may be provided on one shaft 804.

The pressing roller 702 described above is advantageous especially for a thin substrate (for example, a thin glass substrate) to provide the substrate with the degree of freedom in rotation in a horizontally rotating direction and to lightly hold the substrate to such an extent as not to be broken or cracked and transfer the substrate with preventing the substrate from being swept away by the flow of the cleaning solution. The pressing roller 702 is, on the other hand, brought into contact with and biased toward the transfer roller 202 on the lower side, prior to arrival of the substrate WF. There is accordingly a need to lift up the pressing roller 702 when the substrate WF passes through the pressing roller 702. In the case where a common transfer mechanism is employed to transfer both a thin substrate and a thick substrate, however, a transferred thick substrate WF is likely to be stuck in the pressing roller 702 and to fail to lift up the pressing roller 702. The configuration of this embodiment is accordingly provided with the transfer rollers 202 and the upper transfer rollers 802 to hold the thick substrate WF from above and below and to be rotary-driven from above and below. This configuration moves the substrate WF forward in the transfer direction, such that the substrate WF certainly lifts up the pressing roller 702.

Fig. 16 to Fig. 18 illustrate one exemplary configuration that one shaft 804 (one group of the upper transfer rollers 802 at one position in the transfer direction) is provided on an upstream side of each of the pressing rollers 702 on the upstream side and on the downstream side. Two or more shafts 804 (two or more groups of the upper transfer rollers 802 at two or more positions in the transfer direction) may alternatively be provided on the upstream side of each of the pressing rollers 702 on the upstream side and on the downstream side.

In the illustrated embodiment, the diameters of the upper transfer rollers 802 and the shafts 804 are set to be smaller than the diameters of the transfer rollers 202 and the shafts 204 and to be equivalent to the diameters of the pressing rollers 702 and the shafts 704. This configuration allows the top ring 302 of the polishing unit 300 to move without interfering with the pressing rollers 702 and the upper transfer rollers 802, even when there is a significant spatial restriction in the space above the transfer rollers 202.

The friction member 207 and/or the friction material described above may be applied to the upper transfer rollers 802, with a view to allowing the substrate WF to move forward more strongly by the upper transfer rollers 802 and the transfer rollers 202.

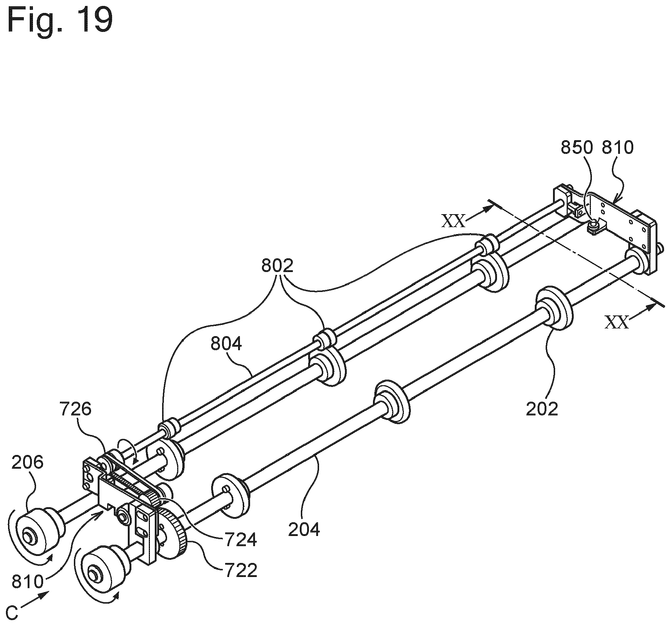

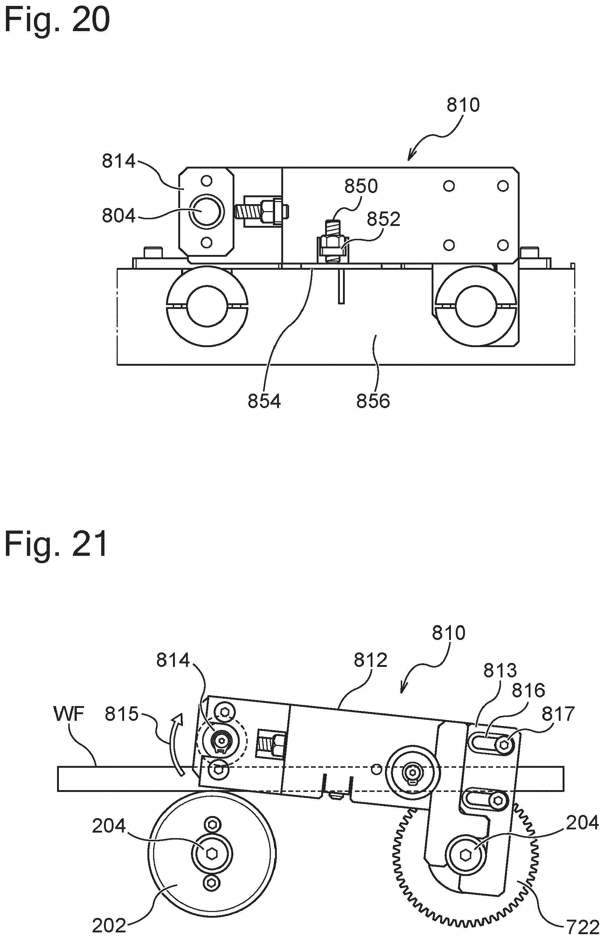

Fig. 19 is a perspective view of a transfer mechanism with close-up of the periphery of the upper transfer rollers. Fig. 20 is a sectional view illustrating the transfer mechanism taken along a line XX-XX and includes a side view illustrating a support mechanism of the upper transfer rollers, viewed from inside of a transfer pathway. Fig. 21 is a side view illustrating the transfer mechanism, viewed in the direction of an arrow C and includes a side view illustrating the support mechanism of the upper transfer rollers, viewed from outside of the transfer pathway. Fig. 21 has transmissive display (omission of illustration) of the gears 206.

The shaft 804 which the upper transfer rollers 802 are mounted to is supported to be freely movable in the vertical direction by roller arms 810 on respective ends thereof. The respective ends of the shaft 804 are attached in a freely rotatable manner to leading ends of the roller arms 810. In the illustrated embodiment, the shaft 804 is attached in a freely rotatable manner to the roller arm 810 via a bearing or the like (not shown) placed in a bearing housing 814 at the leading end of the roller arm 810 shown in Fig. 20 and Fig. 21. A base end of the roller arm 810 is attached in a freely rotatable manner to the shaft 204 of the transfer rollers 202, which is located below and adjacent to the shaft 804 of the upper transfer rollers 802 on an upstream side in the transfer direction F. In the state that the upper transfer rollers 802 and the shaft 804 are lifted up by the substrate WF, the roller arms 810 rotate in the direction of an arrow 815 about the shaft 204. The roller arm 810 includes an arm main body 812 and a bracket 813 attached by bolts 817 to the arm main body 812 via long holes 816. The roller arm 810 is configured to be readily detached from the shaft 204 for maintenance by loosening the bolts 817 and sliding the bracket 813 along the long holes 816 relative to the arm main body 812.

As shown in Fig. 19, the shaft 804 of the upper transfer rollers 802 is connected via a belt 726 and gears 724 and 722 with the shaft 204 that is rotary-driven by the motor 208 and the gears 206. The upper transfer rollers 802 are accordingly rotary-driven by the motor 208 that is a power source identical with the power source for the transfer rollers 202 on the lower side. The connection between the upper transfer rollers 802 and the transfer rollers 202 on the lower side provides belt driving that transmits the power via the belt 726. Even in the case where the diameter of the upper transfer rollers 802 is different from the diameter of the transfer rollers 202, this configuration enables the circumferential speed of the upper transfer rollers 802 to be readily made equal to the circumferential speed of the transfer rollers 202 and allows the substrate WF to move forward without sliding.

A lower limit of displacement initial position of the roller arm 810 (a distance H1 between the transfer rollers 202 on the lower side and the upper transfer rollers 802 shown in Fig. 17) is adjusted by a stopper 850 shown in Fig. 20. The stopper 850 is, for example, in the form of a screw or a bolt. The stopper 850 passes through a threaded hole (not shown) of a flange 852 provided in the roller arm 810, and a leading end of the stopper 850 comes into contact with a base 854. The base 854 is fixed to a member fastened relative to the transfer roller 202 on the lower side, for example, a member such as a rail 856 configured to support the shaft 204 and the like. The initial position of the roller arm 810 is adjustable by regulating a screwing amount (insertion depth) of the stopper 850 into the threaded hole of the flange 852. In other words, the distance H1 between the transfer roller 202 on the lower side and the upper transfer roller 802 is adjustable by the insertion depth of the stopper 850.

The stopper 850 may be a member provided with no adjustment function but configured to fix the roller arm 810 at a desired initial position.

The initial position of the roller arm 810 (the distance H1) is adjusted to such a height that a thin substrate WF (having a thickness d< d1) does not come into contact with the upper transfer rollers 802 when the thin substrate WF passes through the position of the upper transfer roller 802 and is also adjusted to such a height that a thick substrate WF (having a thickness d> d2, d2≥ d1) comes into contact with the upper transfer roller 802 and lifts up the upper transfer roller 802 when the thick substrate WF passes through the position of the upper transfer roller 802. For example, d1 < H1 < d2. The roller arms 810 are rotated in advance around the shaft 204 as a fulcrum to lift up the upper transfer rollers 802 and the shaft 804. The thick substrate WF (for example, a thick glass substrate) has a sufficient strength and is thus allowed to move forward in the transfer direction F without damaging, when the thick substrate WF is held between the upper and the lower transfer rollers (the upper transfer roller 802 and the transfer roller 202 on the lower side) and is rotary-driven from above and below. On the other hand, in the case where the thin substrate WF (for example, a thin glass substrate) is held between the upper and the lower transfer rollers and is rotary-driven from above and below, the roller arms 810 lift the upper transfer rollers 802 to such a height (initial position) that the upper transfer rollers 802 do not come into contact with the transfer rollers 202 on the lower side and do not come into contact with the thin glass substrate WF during transfer, since the thin substrate WF that has insufficient strength is likely to be damaged. This height is indicated by the distance H1 between the transfer roller 202 and the upper transfer roller 802 shown in Fig. 17 and is adjusted according to the thickness of the substrate WF that is to be transferred. In one example, this height is selected such that the distance between the transfer roller 202 and the upper transfer roller 802 is approximately 0.5 mm to 1.5 mm.

The thickness d2 may be set equal to the thickness d1 or may be set greater than the thickness d1. Setting the thickness d2> the thickness d1 enables the distance H1 to be set with some margin according to the thickness type of the substrate that is to be transferred. In this case, the distance H1 may be set with a margin equal to or greater than (d2 - d1), such that the thin substrate WF (having the thickness d< d1) does not certainly come into contact with the upper transfer rollers 802 and such that the thick substrate WF (having the thickness d> d2) certainly lifts up the upper transfer rollers 802.

When the thin substrate WF is transferred to the position of the upper transfer rollers 802, the configuration described above enables the thin substrate WF to pass through below the upper transfer rollers 802 without coming into contact with the upper transfer rollers 802. When the thick substrate WF is transferred to the position of the upper transfer rollers 802, on the other hand, the above configuration causes the substrate WF to lift up the upper transfer rollers 802 and rotate the roller arms 810. This causes the substrate WF to be held from above and below by the upper transfer rollers 802 and the transfer rollers 202 on the lower side and to be rotary-driven from above and below, and thereby allows the substrate WF to certainly push upward the pressing roller 702 on the downstream side of the upper transfer rollers 802 and move forward in the transfer direction F.

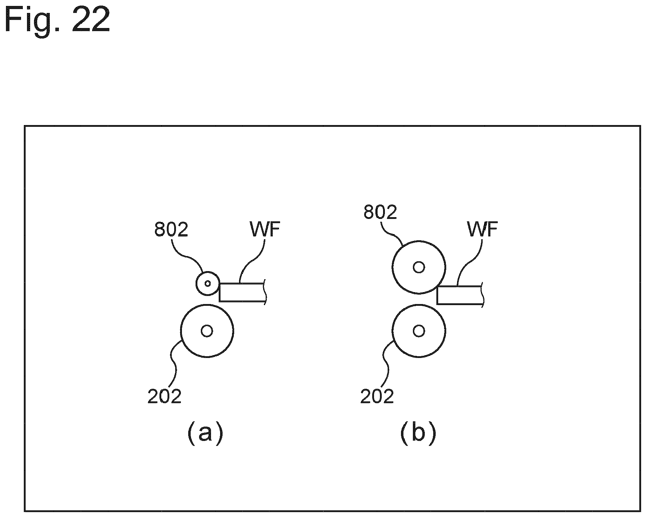

Fig. 22 is explanatory views illustrating driving systems according to different diameters of the upper transfer rollers 802. It is preferable to select the driving system according to the difference in diameter of the upper transfer rollers 802. In the case where the diameter of the upper transfer roller 802 is smaller than the diameter of the transfer roller 202 as shown in Fig. 22(a) (on the contrary, in the case where the diameter of the upper transfer roller 802 is larger than the diameter of the transfer roller 202), it is preferable to connect the shaft 204 of the transfer rollers 202 with the shaft 804 of the upper transfer rollers 802 by a belt for belt driving. The belt driving makes the circumferential speed of the upper transfer roller 802 equal to the circumferential speed of the transfer roller 202 and enables the thick substrate WF to lift up the pressing roller 702 and move forward. In the case where the diameter of the upper transfer roller 802 is as large as the diameter of the transfer roller 202 as shown in Fig. 22(b), the shaft 204 of the transfer rollers 202 may be connected with the shaft 804 of the upper transfer rollers 802 by a belt for belt driving or may be connected with the shaft 804 of the upper transfer rollers 802 directly via a gear without using a belt for gear driving (gear ratio 1:1). According to one embodiment, the gear may be a toothed wheel or may be a magnet gear. The magnet gear is a contactless power transmission mechanism. The magnet gear is accordingly free from generation of fine particles caused by abrasion, unlike a contact gear, and does not need maintenance such as refueling.

(Modifications of Second Embodiment)
(1) The above embodiment illustrates the exemplary configuration of rotary-driving the upper transfer rollers 802 (the shaft 804). One modification may be configured not to rotary-drive the upper transfer rollers 802 (the shaft 804) (a configuration that the upper transfer rollers 802 (the shaft 804) are not connected with any power source but are allowed to rotate freely). This modification may further be configured to fix the shaft 804 and to allow the upper transfer rollers 802 to freely rotate about the shaft 804. Even in the configuration of no rotary-driving of the upper transfer rollers 802, the thick substrate WF may be held at three different positions in the width direction by the upper transfer rollers 802. This enables the thick substrate WF to lift up the pressing roller 702 and move forward without sliding.
(2) One modification of the above embodiment may be configured not to rotary-drive the upper transfer rollers 802 but to increase the weight of the upper transfer rollers 802 (for example, to a maximum possible weight in such a range that does not damage the substrate WF), so as to allow the substrate WF to be more securely held and to move forward in the transfer direction. The upper transfer rollers 802 act only on the thick substrate having a relatively high strength. Even when the weight of the upper transfer rollers 802 is increased, this suppresses or prevents the thick substrate from being damaged. In the case of increasing the weight of the upper transfer rollers 802, the diameter of the upper transfer rollers 802 may be increased (to be equivalent to or greater than the diameter of the transfer rollers 202 on the lower side), with a view to preventing a load from the upper transfer rollers 802 from being locally concentrated on the substrate WF.
(3) One modification of the above embodiment may increase the diameter of the pressing roller 702 (to be equivalent to or greater than the diameter of the transfer roller 202 on the lower side), with a view to enabling the thick substrate WF to lift up the pressing roller 702. In this modification, the upper transfer rollers 802 may be rotary-driven or may not be rotary-driven. This is because the large diameter of the pressing roller 702 causes the thick substrate WF to enter below the pressing roller and readily lift up the pressing roller 702.

The embodiment and its modifications described above illustrate the exemplary configurations that the pressing rollers 702, the upper transfer rollers 802 and the like are provided in the location where the substrate WF receives a supply of the cleaning solution (a liquid or a mixed fluid of a liquid and a gas) from the cleaning nozzles 284. A similar configuration to any of the configurations of the above embodiment and the modifications thereof may be employed in a location where the substrate WF receives a supply of the gas (for example, in a location where the substrate WF receives a supply of the gas from the nozzles 530 in the drying unit 500). A configuration corresponding to the pressing rollers 702 and the upper transfer rollers 802 is omitted from the illustration of Fig. 7.

(Other Embodiments)

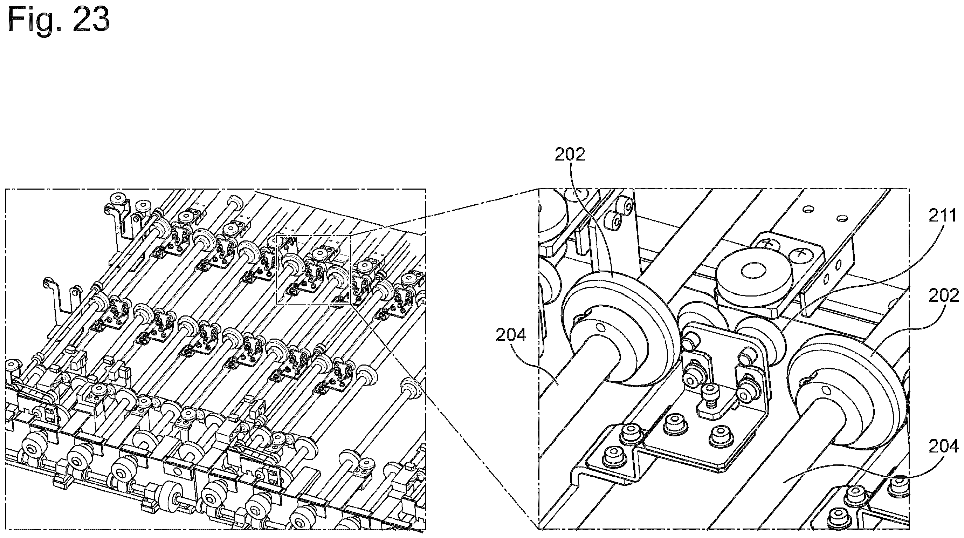

(1) Fig. 23 is a perspective view illustrating auxiliary rollers 211 between the transfer rollers 202 configured to support the lower face of the substrate WF. In the embodiments described above, one or a plurality of auxiliary rollers 211 (one example of fourth transfer rollers) may be placed between the adjacent transfer rollers 202. The auxiliary roller 211 may have a diameter that is equal to, smaller than or larger than the diameter of the transfer roller 202. When the transfer roller 202 and the auxiliary roller 211 have different diameters, the auxiliary roller 211 may be placed such that the height of an upper end of the auxiliary roller 211 is aligned with the height of an upper end of the transfer roller 202 or such that the height of the upper end of the auxiliary roller 211 is slightly lower than the height of the upper end of the transfer roller 202. The auxiliary rollers 211 are not connected with any power source but are configured to be freely rotatable. These auxiliary rollers 211 suppress or prevent the substrate WF from being bent and sagging between the transfer rollers 202. Especially the thin substrate WF is readily bendable and is likely to sag between the transfer rollers 202. Placing the auxiliary rollers 211 between the transfer rollers 202 effectively suppresses or prevents the thin substrate WF from sagging between the transfer rollers 202. Providing the auxiliary rollers 211 between the transfer rollers 202 instead of proving a plate-like support member between the transfer rollers 202 more effectively suppresses or prevents the substrate WF from being scratched or damaged. The configuration of placing the auxiliary rollers 211 between the transfer rollers 202 may be replaced by a configuration of decreasing the diameter of the transfer rollers 202, increasing the number of the transfer rollers 202, and narrowing the interval between the transfer rollers 202 (placing the transfer rollers 202 at such an interval that the substrate WF does not sag between the adjacent first transfer rollers 202), with a view to suppressing or preventing the substrate WF from sagging between the transfer rollers 202.

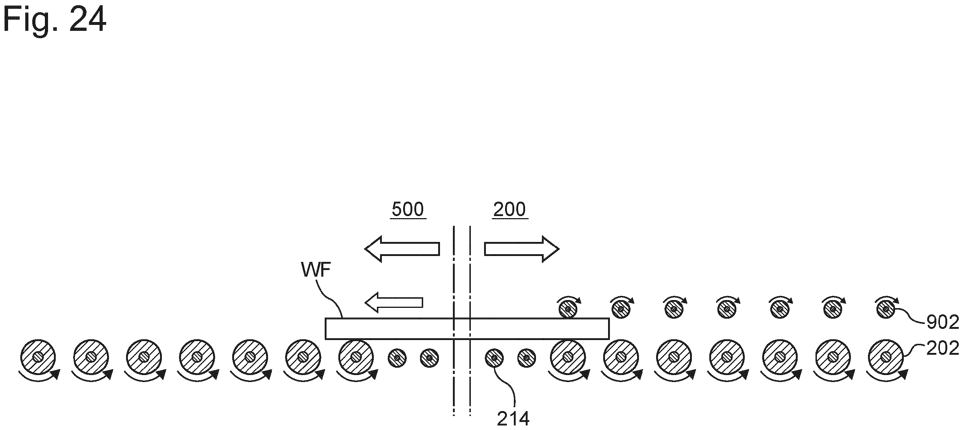

(2) Fig. 24 is a schematic diagram illustrating an example of adding upper transfer rollers in a neighborhood of an inlet/ outlet of a unit. In the embodiment described above, upper transfer rollers that are rotary-driven may be placed in the vicinity of an inlet/ outlet of a unit. Fig. 24 illustrates the transfer unit 200 and the drying unit 500 with rotary-driven upper transfer rollers 902 (one example of fifth transfer rollers) placed in the vicinity of an outlet of the transfer unit 200. The upper transfer rollers 902 may have a similar configuration to that of the upper transfer rollers 802 described above and may be provided with related parts similar to the related parts (the shaft, the support mechanism and the driving mechanism) of the upper transfer rollers 802 described above. In the configuration of Fig. 24, the rotary-driven upper transfer rollers 902 may be placed in the vicinity of each of the inlets and the outlets of the transfer unit 200 and of the drying unit 500. Rotary-driven upper transfer rollers may similarly be placed in the vicinity of an inlet/ outlet of another unit other than those illustrated in Fig. 24.

Auxiliary rollers 214 between the units are not rotary-driven, so that the substrate WF is likely to stagnate in this location. Especially in the case of a warped substrate having rigidity, only a center portion of the substrate may come into contact with the auxiliary rollers 214, while end portions of the substrate may be separated away from the transfer rollers 202. This may cause the transfer rollers 202 to idle and may stop the substrate between the units. Placing the rotary-driven upper transfer rollers 902 in the vicinity of an inlet/ outlet of each unit enables the substrate WF to be stably transferred without decreasing the transfer speed of the substrate WF.

The upper transfer rollers 902 may be provided corresponding to all the transfer rollers 202 (the shaft 204) on the lower side. This configuration more effectively keeps the transfer speed of the substrate WF. In the case where the upper transfer rollers 902 having the small diameter are provided with a power transmission mechanism, a load on the side of the upper transfer rollers 902 is likely to be locally concentrated on the substrate WF and to damage the substrate WF (especially a thin glass substrate). The configuration shown in Fig. 24 may accordingly be applied only for the thick substrate WF. In the case where there is little spatial restriction in the space above the transfer rollers 202, the diameter of the upper transfer rollers 902 may be increased (to be equivalent to or greater than the diameter of the transfer rollers 202 on the lower side).

At least the following technical concepts are provided from the description of the above embodiments.
[1] According to one aspect, there is provided a substrate transfer apparatus configured to transfer a substrate in a rectangular shape. The substrate transfer apparatus comprises a plurality of first transfer rollers configured to support a lower face of the substrate; a plurality of first roller shafts, wherein at least three first transfer rollers are mounted to each of the first roller shafts, such as to support at least respective end portions and a center portion of the substrate in a width direction that is perpendicular to a transfer direction of the substrate; a motor configured to rotate the first roller shafts; a plurality of second transfer rollers configured to support an upper face of the substrate at only the center portion of the substrate in the width direction; a plurality of second roller shafts, wherein one second transfer roller configured to support only the center portion of the substrate in the width direction is mounted to each of the second roller shafts; and a plurality of guide rollers opposed to respective side faces of the substrate and configured to guide transfer of the substrate.
   The configuration of this aspect causes the substrate to be supported from above and below by the first transfer rollers and the second transfer rollers. In the case where a fluid is sprayed onto the substrate in a fluid processing module, this configuration suppresses or prevents the substrate from being swept away by the flow of the fluid. Furthermore, this configuration causes the upper face of the substrate to be held at only the center portion of the substrate in the width direction by the second transfer rollers and thereby provides the substrate with a degree of freedom in rotation in a horizontal direction. Even in the case where the substrate meanders and comes into contact with the guide roller, this configuration allows the substrate to rotate in a releasing direction from the guide roller before the substrate is pressed hard against the guide roller. This configuration accordingly suppresses or prevents the substrate from being damaged.
[2] According to one aspect, in the substrate transfer apparatus, the second transfer rollers and component parts configured to hold the second transfer rollers in a rotatable manner may have specifications that are set, based on material information and thickness information of a substrate having a lowest strength out of substrates to be transferred, wherein the component parts may include the second roller shafts and a support mechanism configured to support the second roller shafts, and the specifications may include a total weight of the second transfer rollers and the component parts, a diameter of the second transfer rollers, a diameter of the second roller shafts, and/or materials of the second transfer rollers and the component parts.
   The configuration of this aspect sets the specifications of the second transfer rollers and the component parts configured to hold the second transfer rollers in a rotatable manner, based on the material information and the thickness information of the substrate having the lowest strength out of the substrates to be transferred. This configuration accordingly suppresses or prevents a thin substrate (especially, a thin glass substrate) from being damaged by a load applied to the upper face of the substrate from the second transfer rollers-side during transfer of the substrate.
[3] According to one aspect, in the substrate transfer apparatus, the second transfer rollers may have a diameter that is smaller than a diameter of the first transfer rollers, and the second roller shafts may have a diameter that is smaller than a diameter of the first roller shafts.
   In the case where there is a significant spatial restriction in the space above a transfer mechanism, the configuration of this aspect suppresses or prevents a structure (for example, a top ring of a polishing unit) that is present above the transfer mechanism or that passes through above the transfer mechanism, from interfering with the second transfer roller and/or the second roller shaft.
[4] According to one aspect, in the substrate transfer apparatus, either one or both of the first transfer roller and the second transfer roller may include a friction member and/or a friction material in at least a location that comes into contact with the substrate.

With a view to effectively providing the substrate with a driving force in the transfer direction, it is preferable that the rotary-driven transfer roller is provided with the friction member and/or the friction material. Accordingly, it is preferable that the rotary-driven roller out of the first and the second transfer rollers includes the friction member and/or the friction material. The expression of "including the friction member" means that the friction member is attached to the transfer roller, and the expression of "including the friction material" means that part or the entirety of the transfer roller is made of the friction material.

The configuration of this aspect enhances the friction between the substrate and the first transfer roller and/or the second transfer roller by the friction member and/or the friction material and enables the substrate to be efficiently pressed forward in the transfer direction. This more effectively suppresses or prevents the substrate from being swept away by the flow of the fluid that is supplied from the fluid processing module to the substrate.

[5] According to one aspect, in the substrate transfer apparatus, each of the second transfer rollers may be placed to be opposed to one of the plurality of first transfer rollers, and the friction member and/or the friction material may be included in either one or both of the first transfer roller and the second transfer roller that are opposed to each other.

In the configuration of this aspect, the friction member and/or the friction material is included in the first transfer roller and/or the second transfer roller in a location where the substrate is held from above and below by the first transfer roller and the second transfer roller. This configuration accordingly enables the substrate to be more efficiently pressed forward in the transfer direction. This more effectively suppresses or prevents the substrate from being swept away by the flow of the fluid that is supplied from the fluid processing module to the substrate.

[6] According to one aspect, the substrate transfer apparatus may further comprise a fluid processing module configured to supply a fluid to the substrate to be opposed to the transfer direction of the substrate on a transfer pathway of the substrate, wherein the plurality of second transfer rollers may include two second transfer rollers, and the two second transfer rollers may be arranged on an upstream side and on a downstream side of an area where the substrate receives the supply of the fluid and may be placed across a first distance along the transfer direction, wherein the first distance may be set, such that the two second transfer rollers are placed at such positions as to allow the second transfer rollers to respectively and simultaneously come into contact with a front end portion and with a rear end portion of the substrate along the transfer direction of the substrate.

The configuration of this aspect causes the substrate to be continuously held by at least one second transfer roller, while the substrate is exposed to the fluid. This prevents the substrate from being swept away by the flow of the fluid. Furthermore, in the configuration of this aspect, the substrate is held by two second transfer rollers for only a short time period. Even in the case where the substrate meanders and comes into contact with the guide roller, this configuration allows the substrate to rotate in a releasing direction from the guide roller before the substrate is pressed hard against the guide roller. In the state that no second transfer roller is brought into contact with the substrate, the substrate is swept away by the flow of the fluid. In the state that two or more second transfer rollers are placed on the substrate, however, the substrate is not allowed to rotate in a horizontal direction and has a risk of being pressed against the guide roller in the event of meandering of the substrate (a risk of being damaged). It is accordingly preferable to minimize a time period when the two second transfer rollers are brought into contact with the substrate. The above configuration that the first distance that is an interval between the second transfer rollers is determined according to the length of the substrate (i.e., the configuration that the first distance is set to be slightly shorter than the length of the substrate, such that the second transfer rollers on an upstream side and on a downstream side are brought into contact with the substrate with being placed away from each other as much as possible in a length direction of the substrate) satisfies a condition that either one of the second transfer rollers is continuously brought into contact with the substrate and a condition that the time period when a plurality of the second transfer rollers are brought into contact with the substrate is shortened as much as possible.

[7] According to one aspect, in the substrate transfer apparatus, a first rotation transmission mechanism may be provided between the first roller shafts and the second roller shafts, and power from the motor configured to rotate the first roller shafts may be transmitted via the first rotation transmission mechanism to the second roller shaft, so as to rotate the second roller shafts.

The first rotation transmission mechanism may be configured, for example, by a gear system (a mechanical toothed wheel or a magnet gear) or by a belt system (a toothed wheel and a belt).

The configuration of rotary-driving the second roller shafts (the second transfer rollers) increases the weight on the second transfer rollers-side and increases a load applied downward to the substrate. In order to prevent a load from being locally applied on the substrate, it is preferable to increase the diameter of the second transfer rollers (for example, to be equivalent to or greater than the diameter of the first transfer rollers).

In the configuration of this aspect, rotary-driving of the second transfer rollers enables the substrate to be pressed forward in the transfer direction by providing the substrate with a driving force from above and below. This more effectively suppresses or prevents the substrate from being pushed back by the flow of the fluid from the fluid processing module.

[8] According to one aspect, in the substrate transfer apparatus, the first rotation transmission mechanism may be configured such that a circumferential speed of the second transfer rollers is made equal to a circumferential speed of the first transfer rollers.

The configuration of this aspect provides the substrate with a driving force by the upper and lower transfer rollers rotating at an identical circumferential speed and thereby enables the substrate to be efficiently pressed forward in the transfer direction. This more effectively suppresses or prevents the substrate from being pushed back by the flow of the fluid from the fluid processing module.

[9] According to one aspect, in the substrate transfer apparatus, the second transfer rollers may be configured not to be connected with any power source and may be configured to be freely rotatable.

The configuration of this aspect simplifies the structure on the second transfer rollers-side (the second transfer rollers, the second roller shafts, and a support mechanism of the second roller shafts). This configuration also suppresses an increase in the weight on the second transfer rollers-side and suppresses or prevents the substrate from being damaged by a load applied from the second transfer rollers.

[10] According to one aspect, in the substrate transfer apparatus, the second transfer roller may be supported to be freely movable in a vertical direction, such as to come into contact with the first transfer roller, and the second transfer roller may be configured to be lifted up by the substrate when the substrate reaches the second transfer roller.

The configuration of this aspect allows the upper face of the substrate to be pressed by the weight on the second transfer rollers-side.

[11] According to one aspect, in the substrate transfer apparatus, the second transfer roller may be supported by a first roller arm configured to rotate around the first roller shaft that is other than the first roller shaft corresponding to the second transfer roller, as a fulcrum.

The "first roller shaft that is other than the first roller shaft corresponding to the second transfer roller" excludes the first roller shaft immediately below the second transfer roller (the second roller shaft) and means, for example, the first roller shaft adjacent to the second transfer roller (the second roller shaft) on an upstream side or on a downstream side or the first roller shaft that is away across one or a plurality of the first roller shafts.

The configuration of this aspect provides a simple structure that allows the upper face of the substrate to be pressed by the weight on the second transfer rollers-side.

[12] According to one aspect, the substrate transfer apparatus may further comprise a plurality of third transfer rollers placed on an upstream side of each of the second transfer rollers in the transfer direction and configured to support the upper face of the substrate; and a plurality of third roller shafts configured such that at least three third transfer rollers are mounted to each of the third roller shafts, wherein the third roller shafts may be supported to be freely movable in a vertical direction in a state that the first transfer rollers and the third transfer rollers are separated away in the vertical direction from each other across a second distance.

In the configuration of this aspect, appropriately setting the second distance allows a thin substrate having a low strength to pass through below the third transfer rollers without being brought into contact with the third transfer roller, and does not reduce the degree of freedom in rotation of the thin substrate in the horizontal direction. This accordingly allows the thin substrate having the low strength to rotate in a releasing direction from the guide roller, even when the substrate is brought into contact with the guide roller. Furthermore, this configuration prevents the thin substrate having the low strength from being broken or cracked by the weight of the third transfer rollers.

A thick substrate having a high strength, on the other hand, pushes up the third transfer roller and is pressed downward by the third transfer roller, and is thus strongly pressed forward in the transfer direction. This configuration enables the thick substrate to lift up the second transfer roller and to advance in the transfer direction without being stuck by the second transfer roller that comes into contact with the first transfer roller. In this case, the degree of freedom in rotation in the horizontal direction of the thick substrate pressed by the third transfer roller is reduced to some extent. The thick substrate, however, has the high strength and is thus unlikely to be damaged even when the thick substrate is pressed against the guide roller. Moreover, the third transfer rollers are placed such as to be separated in advance from the first transfer rollers. The thick substrate can thus readily push up the third transfer rollers.

[13] According to one aspect, in the substrate transfer apparatus, the second distance may be set such that the substrate having a thickness smaller than a first thickness does not come into contact with the third transfer rollers but passes through below the third transfer rollers and that the third transfer rollers are lifted up by the substrate having a thickness greater than a second thickness, wherein the second thickness may be equal to or greater than the first thickness. For example, the second distance is set to be greater than the first thickness and to be smaller than the second thickness.

The configuration of this aspect allows multiple different types of substrates having different thicknesses to be transferred. This suppresses or prevents a substrate having a smaller thickness than the first thickness (a thin substrate) from being damaged and enables a substrate having a greater thickness than the second thickness (a thick substrate) to certainly lift up the second transfer roller.

[14] According to one aspect, the substrate transfer apparatus may be configured to transfer substrates having different thicknesses and may be allowed to transfer a substrate having a first thickness and a substrate having a second thickness that is greater than the first thickness, wherein the second distance may be greater than the first thickness but is smaller than the second thickness.

The configuration of this aspect allows two different types of substrates having different thicknesses to be transferred. This suppresses or prevents a thin substrate (a substrate having the first thickness) from being damaged and enables a thick substrate (a substrate having the second thickness) to certainly lift up the second transfer roller.

[15] According to one aspect, the substrate transfer apparatus may further comprise a second roller arm configured to rotate around the first roller shaft that is other than the first roller shaft corresponding to the third transfer roller, as a furculum and to support the third roller shaft to be freely movable in the vertical direction; and a stopper configured to support the second roller arm, such that a distance between the first transfer rollers and the third transfer rollers does not become smaller than the second distance.

The "first roller shaft that is other than the first roller shaft corresponding to the third transfer roller" excludes the first roller shaft immediately below the third transfer roller (the third roller shaft) and means, for example, the first roller shaft adjacent to the third transfer roller (the third roller shaft) on an upstream side or on a downstream side or the first roller shaft that is away across one or a plurality of the first roller shafts.

The configuration of this aspect provides a simple structure that allows the thin substrate to pass through without coming into contact with the third transfer roller, while allowing the thick substrate to be pressed by the dead weight on the third transfer rollers-side.

[16] According to one aspect, in the substrate transfer apparatus, the stopper may be configured to regulate the distance between the first transfer rollers and the third transfer rollers.

The configuration of this aspect enables a distance between the first transfer rollers and the third transfer rollers (a lowest point of the third transfer rollers) to be adjusted to an optimum distance (height) according to the thickness type of the substrate that is to be transferred. Accordingly, this configuration enables the distance between the first transfer rollers and the third transfer rollers to be readily optimized with a change in thickness type of the substrate that is to be transferred.

[17] According to one aspect, in the substrate transfer apparatus, a second rotation transmission mechanism may be provided between the first roller shafts and the third roller shafts, and power from the motor configured to rotate the first roller shafts may be transmitted via the second rotation transmission mechanism to the third roller shafts, so as to rotate the third roller shafts.

The second rotation transmission mechanism may be configured, for example, by a gear system (a mechanical toothed wheel or a magnet gear) or by a belt system (a toothed wheel and a belt).

The third roller shaft (the third transfer roller) may be rotary-driven. This configuration enables a thick substrate to be more strongly pressed forward in the transfer direction by the first transfer rollers and the third transfer rollers. The configuration of rotary-driving the third roller shafts (the third transfer rollers) increases the weight on the third transfer rollers-side and increases a load applied downward to the substrate. This configuration, however, causes the third transfer rollers not to come into contact with a thin substrate. This accordingly suppresses or prevents the substrate from being damaged by the weight on the third transfer rollers-side. One modification may increase the diameter of the third transfer rollers (to be equivalent to or greater than the diameter of the first transfer rollers), in order to prevent a load from the third transfer rollers from being locally concentrated on the substrate.

The configuration of this aspect additionally drives the third transfer rollers and thus enables the substrate to be pressed forward in the transfer direction by both the first transfer rollers and the third transfer rollers. This enables the substrate to be strongly pressed forward in the transfer direction and to certainly lift up the second transfer roller that is in contact with the first transfer roller.

[18] According to one aspect, in the substrate transfer apparatus, the second rotation transmission mechanism may be configured such that a circumferential speed of the third transfer rollers is made equal to a circumferential speed of the first transfer rollers.

The configuration of this aspect provides the substrate with a driving force by the upper and lower transfer rollers rotating at an identical circumferential speed and thereby enables the substrate to be efficiently pressed forward in the transfer direction. This furthermore assures that the substrate lifts up the second transfer roller.

[19] According to one aspect, in the substrate transfer apparatus, one or a plurality of fourth transfer rollers that are not connected with any power source but that are configured to be freely rotatable may be placed between the first transfer rollers that are adjacent to each other, or the plurality of first transfer rollers may be placed across such a distance that the substrate does not sag between the first transfer rollers that are adjacent to each other.

In the configuration of this aspect, the fourth transfer rollers are placed between the first transfer rollers, or the plurality of first transfer rollers are placed across the distance that the substrate does not sag between the adjacent first transfer rollers. This configuration suppresses or prevents the substrate from sagging between the first transfer rollers.

[20] According to one aspect, the substrate transfer apparatus may be provided with a plurality of units including the plurality of first transfer rollers, and the substrate transfer apparatus may further comprise a plurality of fifth transfer rollers provided corresponding to the first transfer rollers placed adjacent to an inlet or an outlet of at least one unit and configured to support the upper face of the substrate.

The transfer rollers between the units are not rotary-driven, so that the transfer speed of the substrate is likely to decrease in this location. In the configuration of this aspect, however, the first transfer rollers and the fifth transfer rollers in the vicinity of the inlet or the outlet of each unit provide the substrate with a driving force from above and below. This enables the substrate to be stably transferred without reducing the transfer speed. In the case where the fifth transfer rollers have a small diameter, providing a power transmission mechanism for the fifth transfer rollers is likely to cause a load on the fifth transfer rollers-side to be locally concentrated on the substrate WF and is thereby likely to damage the substrate WF (especially, a thin glass substrate). The above configuration may accordingly be provided as a configuration exclusive for thick substrates WF. In the case where there is little spatial restriction in a space above the first transfer rollers, the diameter of the fifth transfer rollers may be increased (to be equivalent to or greater than the diameter of the first transfer rollers).

[21] According to one aspect, there is provided an apparatus for processing a substrate, comprising the substrate transfer apparatus described above; a substrate processing module configured to process the substrate; a substrate transfer mechanism configured to transfer the substrate between the substrate transfer apparatus and the substrate processing module; and a fluid processing module placed in the substrate transfer apparatus and configured to supply a fluid to the substrate to be opposed to a transfer direction of the substrate on a transfer pathway of the substrate.

The configuration of this aspect suppresses or prevents the substrate from being swept away by the flow of the fluid in the fluid processing apparatus placed in the apparatus for processing the substrate or the substrate processing apparatus and also suppresses or prevents the substrate from being pressed hard against the guide rollers and from being damaged. Furthermore, this configuration has other functions and advantageous effects described above.

[22] According to one aspect, in the apparatus for processing the substrate, the substrate processing module may comprise a polishing table configured to rotate; and a top ring configured to hold the substrate, press the substrate against a polishing surface of the polishing table, and rotate, and the substrate transfer mechanism may transfer the substrate between the substrate transfer apparatus and the top ring.

The configuration of this aspect suppresses or prevents the substrate from being swept away by the flow of the fluid in the fluid processing apparatus placed in the substrate processing apparatus equipped with a polishing unit, and also suppresses or prevents the substrate from being pressed hard against the guide rollers and from being damaged.

[23] According to one aspect, there is provided a substrate transfer method of transferring a substrate in a rectangular shape. The substrate transfer method comprises while guiding transfer of the substrate by a plurality of guide rollers opposed to respective side faces of the substrate in a width direction, which is perpendicular to a transfer direction of the substrate, transferring the substrate in such a state that the substrate is held from above and below by first transfer rollers and second transfer rollers, wherein at least three first transfer rollers are mounted to each of a plurality of first roller shafts arranged along the transfer direction, such as to support a lower face of the substrate at respective end portions and a center portion of the substrate in the width direction, and the second transfer roller is mounted to each of a plurality of second roller shafts arranged along the transfer direction, such as to support an upper face of the substrate at only the center portion of the substrate in the width direction, and wherein number of the second roller shafts is less than number of the first roller shafts.

The configuration of this aspect causes the substrate to be supported from above and below by the first transfer rollers and the second transfer rollers. In the case where a fluid is sprayed onto the substrate in a fluid processing module, this configuration suppresses or prevents the substrate from being swept away by the flow of the fluid. Furthermore, this configuration causes the upper face of the substrate to be held at only the center portion of the substrate in the width direction by the second transfer rollers and thereby provides the substrate with a degree of freedom in rotation in a horizontal direction. Even in the case where the substrate meanders and comes into contact with the guide roller, this configuration allows the substrate to rotate in a releasing direction from the guide roller before the substrate is pressed hard against the guide roller. This configuration accordingly suppresses or prevents the substrate from being damaged.

Although the embodiments of the present invention have been described based on some examples, the embodiments of the invention described above are presented to facilitate understanding of the present invention, and do not limit the present invention. The present invention can be altered and improved without departing from the subject matter of the present invention, and it is needless to say that the present invention includes equivalents thereof. In addition, it is possible to arbitrarily combine or omit respective constituent elements described in the claims and the specification in a range where at least a part of the above-mentioned problem can be solved or a range where at least a part of the effect is exhibited.

The present application claims priority to Japanese patent application No. 2023-62559 filed on April 7, 2023. The entire disclosure of Japanese patent application No. 2023-62559 filed on April 7, 2023, including the specification, claims, drawings and abstract is incorporated herein by reference in its entirety.

The entire disclosures of Japanese Unexamined Patent Publication No. 2020-009987 (PTL 1) and Japanese Unexamined Patent Publication No. 2020-053421 (PTL 2), and Japanese Unexamined Patent Publication No. 2014-176950, including the specifications, claims, drawings and abstracts are incorporated herein by reference in their entireties.

### REFERENCE SIGNS LIST

- 10: pattern area
- 20: non-pattern area
- 100: loading unit
- 200: transfer unit
- 202: transfer roller
- 204: roller shaft
- 206: gear
- 207: friction member
- 208: motor
- 211: auxiliary roller
- 212: guide roller
- 214: auxiliary roller
- 216: sensor
- 218: inlet shutter
- 220: stopper
- 222: stopper moving mechanism
- 230: pusher
- 283: cleaning module
- 284: cleaning nozzle
- 286: outlet shutter
- 300: polishing unit
- 302: top ring
- 350: polishing table
- 352: polishing pad
- 500: drying unit
- 530: nozzle
- 600: unloading unit
- 702: pressing roller
- 704: roller shaft
- 710: roller arm
- 712: arm main body
- 713: bracket
- 714: bearing housing
- 716: long hole
- 717: bolt
- 722: gear
- 724: gear
- 726: belt
- 802: upper transfer roller
- 804: roller shaft
- 810: roller arm
- 812: arm main body
- 813: bracket
- 814: bearing housing
- 816: long hole
- 817: bolt
- 850: stopper
- 854: base
- 856: rail
- 902: upper transfer roller
- 900: controller
- 1000: substrate processing apparatus
- WF: substrate

## Claims

1. A substrate transfer apparatus configured to transfer a substrate in a rectangular shape, comprising:
a plurality of first transfer rollers configured to support a lower face of the substrate;
a plurality of first roller shafts, wherein at least three first transfer rollers are mounted to each of the first roller shafts, such as to support at least respective end portions and a center portion of the substrate in a width direction that is perpendicular to a transfer direction of the substrate;
a motor configured to rotate the first roller shafts;
a plurality of second transfer rollers configured to support an upper face of the substrate at only the center portion of the substrate in the width direction;
a plurality of second roller shafts, wherein one second transfer roller configured to support only the center portion of the substrate in the width direction is mounted to each of the second roller shafts; and
a plurality of guide rollers opposed to respective side faces of the substrate and configured to guide transfer of the substrate.

2. The substrate transfer apparatus according to claim 1,
wherein the second transfer rollers and component parts configured to hold the second transfer rollers in a rotatable manner have specifications that are set, based on material information and thickness information of a substrate having a lowest strength out of substrates to be transferred, wherein
the component parts include the second roller shafts and a support mechanism configured to support the second roller shafts, and
the specifications include a total weight of the second transfer rollers and the component parts, a diameter of the second transfer rollers, a diameter of the second roller shafts, and/or materials of the second transfer rollers and the component parts.

3. The substrate transfer apparatus according to claim 1,
wherein the second transfer rollers have a diameter that is smaller than a diameter of the first transfer rollers, and
the second roller shafts have a diameter that is smaller than a diameter of the first roller shafts.

4. The substrate transfer apparatus according to claim 1,
wherein either one or both of the first transfer roller and the second transfer roller includes a friction member and/or a friction material in at least a location that comes into contact with the substrate.

5. The substrate transfer apparatus according to claim 4,
wherein each of the second transfer rollers is placed to be opposed to one of the plurality of first transfer rollers, and
the friction member and/or the friction material is included in either one or both of the first transfer roller and the second transfer roller that are opposed to each other.

6. The substrate transfer apparatus according to claim 1, further comprising:
a fluid processing module configured to supply a fluid to the substrate to be opposed to the transfer direction of the substrate on a transfer pathway of the substrate, wherein
the plurality of second transfer rollers include two second transfer rollers, and
the two second transfer rollers are arranged on an upstream side and on a downstream side of an area where the substrate receives the supply of the fluid and are placed across a first distance along the transfer direction, wherein
the first distance is set, such that the two second transfer rollers are placed at such positions as to allow the second transfer rollers to respectively and simultaneously come into contact with a front end portion and with a rear end portion of the substrate along the transfer direction of the substrate.

7. The substrate transfer apparatus according to claim 1,
wherein a first rotation transmission mechanism is provided between the first roller shafts and the second roller shafts, and
power from the motor configured to rotate the first roller shafts is transmitted via the first rotation transmission mechanism to the second roller shaft, so as to rotate the second roller shafts.

8. The substrate transfer apparatus according to claim 7,
wherein the first rotation transmission mechanism is configured such that a circumferential speed of the second transfer rollers is made equal to a circumferential speed of the first transfer rollers.

9. The substrate transfer apparatus according to claim 1,
wherein the second transfer rollers are not connected with any power source and are configured to be freely rotatable.

10. The substrate transfer apparatus according to claim 1,
wherein the second transfer roller is supported to be freely movable in a vertical direction, such as to come into contact with the first transfer roller, and
the second transfer roller is configured to be lifted up by the substrate when the substrate reaches the second transfer roller.

11. The substrate transfer apparatus according to claim 10,
wherein the second transfer roller is supported by a first roller arm configured to rotate around the first roller shaft that is other than the first roller shaft corresponding to the second transfer roller, as a fulcrum.

12. The substrate transfer apparatus according to claim 1, further comprising:
a plurality of third transfer rollers placed on an upstream side of each of the second transfer rollers in the transfer direction and configured to support the upper face of the substrate; and
a plurality of third roller shafts configured such that at least three third transfer rollers are mounted to each of the third roller shafts, wherein
the third roller shafts are supported to be freely movable in a vertical direction in a state that the first transfer rollers and the third transfer rollers are separated away in the vertical direction from each other across a second distance.

13. The substrate transfer apparatus according to claim 12,
wherein the second distance is set such that the substrate having a thickness smaller than a first thickness does not come into contact with the third transfer rollers but passes through below the third transfer rollers and that the third transfer rollers are lifted up by the substrate having a thickness greater than a second thickness, wherein
the second thickness is equal to or greater than the first thickness.

14. The substrate transfer apparatus according to claim 12,
the substrate transfer apparatus being configured to transfer substrates having different thicknesses and being allowed to transfer a substrate having a first thickness and a substrate having a second thickness that is greater than the first thickness, wherein
the second distance is greater than the first thickness but is smaller than the second thickness.

15. The substrate transfer apparatus according to claim 12, further comprising:
a second roller arm configured to rotate around the first roller shaft that is other than the first roller shaft corresponding to the third transfer roller, as a furculum and to support the third roller shaft to be freely movable in the vertical direction; and
a stopper configured to support the second roller arm, such that a distance between the first transfer rollers and the third transfer rollers does not become smaller than the second distance.

16. The substrate transfer apparatus according to claim 15,
wherein the stopper is configured to regulate the distance between the first transfer rollers and the third transfer rollers.

17. The substrate transfer apparatus according to claim 12,
wherein a second rotation transmission mechanism is provided between the first roller shafts and the third roller shafts, and
power from the motor configured to rotate the first roller shafts is transmitted via the second rotation transmission mechanism to the third roller shafts, so as to rotate the third roller shafts.

18. The substrate transfer apparatus according to claim 17,
wherein the second rotation transmission mechanism is configured such that a circumferential speed of the third transfer rollers is made equal to a circumferential speed of the first transfer rollers.

19. The substrate transfer apparatus according to claim 1,
wherein one or a plurality of fourth transfer rollers that are not connected with any power source but that are configured to be freely rotatable are placed between the first transfer rollers that are adjacent to each other, or
the plurality of first transfer rollers are placed across such a distance that the substrate does not sag between the first transfer rollers that are adjacent to each other.

20. The substrate transfer apparatus according to claim 1,
the substrate transfer apparatus being provided with a plurality of units including the plurality of first transfer rollers,
the substrate transfer apparatus further comprising:
a plurality of fifth transfer rollers provided corresponding to the first transfer rollers placed adjacent to an inlet or an outlet of at least one unit and configured to support the upper face of the substrate.

21. An apparatus for processing a substrate, comprising:
the substrate transfer apparatus according to any one of claims 1 to 20;
a substrate processing module configured to process the substrate;
a substrate transfer mechanism configured to transfer the substrate between the substrate transfer apparatus and the substrate processing module; and
a fluid processing module placed in the substrate transfer apparatus and configured to supply a fluid to the substrate to be opposed to a transfer direction of the substrate on a transfer pathway of the substrate.

22. The apparatus for processing the substrate according to claim 21,
wherein the substrate processing module comprises:
a polishing table configured to rotate; and
a top ring configured to hold the substrate, press the substrate against a polishing surface of the polishing table, and rotate,
wherein the substrate transfer mechanism transfers the substrate between the substrate transfer apparatus and the top ring.

23. A substrate transfer method of transferring a substrate in a rectangular shape, the substrate transfer method comprising:
while guiding transfer of the substrate by a plurality of guide rollers opposed to respective side faces of the substrate in a width direction, which is perpendicular to a transfer direction of the substrate, transferring the substrate in such a state that the substrate is held from above and below by first transfer rollers and second transfer rollers,
wherein at least three first transfer rollers are mounted to each of a plurality of first roller shafts arranged along the transfer direction, such as to support a lower face of the substrate at respective end portions and a center portion of the substrate in the width direction, and
the second transfer roller is mounted to each of a plurality of second roller shafts arranged along the transfer direction, such as to support an upper face of the substrate at only the center portion of the substrate in the width direction, and
wherein number of the second roller shafts is less than number of the first roller shafts.
